# EUROPEAN PATENT SPECIFICATION

(11) **EP 3 919 273 B1**
(45) Date of publication and mention of the grant of the patent: **18.06.2025**
(21) Application number: 20749521.9
(22) Date of filing: 15.01.2020
(51) Int. Cl.: G03F 7/30

(54) **WASHING-OUT DEVICE AND WASHING-OUT METHOD**
AUSWASCHVORRICHTUNG UND AUSWASCHVERFAHREN
DISPOSITIF DE LAVAGE ET PROCÉDÉ DE LAVAGE

(30) Priority: 30.01.2019 JP 2019014456; 24.04.2019 JP 2019083033
(43) Date of publication of application: 08.12.2021
(73) Proprietor: FUJIFILM Corporation, Tokyo 106-8620 (JP)
(72) Inventor: IKEYAMA, Yusuke, Shizuoka 421-0396 (JP); SONE, Nobuyuki, Shizuoka 421-0396 (JP); OSHIMA, Atsushi, Shizuoka 421-0396 (JP)
(74) Representative: Hoffmann Eitle
(86) International application number: PCT/JP2020/000965
(87) International publication number: WO 2020/158380

(56) References cited:
- JP-A- 2000 296 367
- JP-A- 2004 174 385
- JP-A- 2006 075 205
- JP-A- 2011 064 796
- JP-A- 2018 141 923
- JP-A- H06 278 578
- US-A1- 2018 281 500

## Description

### BACKGROUND OF THE INVENTION

### 1. Field of the Invention

The present invention relates to a washing device and a washing method that develop a flexographic printing plate precursor after imagewise exposure using a washing solution, and particularly to a washing device and a washing method that develop a flexographic printing plate precursor in a state in which the flexographic printing plate precursor is immersed in a washing solution and transported.

### 2. Description of the Related Art

Various methods are known as a method of developing a printing plate using a photosensitive resin plate. For example, in a developing method in which development is performed using an aqueous developer including water as a main component, development is performed by washing out an uncured resin, which is an unexposed portion, with a brush or the like while applying the aqueous developer to a photosensitive resin plate after imagewise exposure.

For example, JP1999-133625A (JP-H11-133625A) describes a developing device for a photosensitive resin plate, which removes a resin material of an unexposed portion using a brush, by immersing an exposed photosensitive resin plate in a developer or spraying a developer thereon, the device including a mechanism for causing the photosensitive resin plate and/or the brush to circularly move and a mechanism for further causing a central axis of the circular motion to circularly move.

JP2005-208371A discloses a plate producing device for a photosensitive resin plate, the device including a device main body consisting of an upper portion and a lower portion which are pivotally attached to each other so as to be opened and closed, in which the lower portion is provided with a fixing base for fix a photosensitive resin plate, the upper portion is provided with a washing brush and a driving mechanism for driving the washing brush, the driving mechanism consist of a circular motion generating mechanism and a linear reciprocating motion generation mechanism for causing the circular motion generating mechanism to generate a linear reciprocating motion, and the washing brush is arranged such that bristle tips face down.

Further examples of previously known washing devices and washing methods are derivable from JP 2018 141923 A, JP 2011 064796 A, and US 2018/281500 A1.

### SUMMARY OF THE INVENTION

In the developing device for a photosensitive resin plate of JP1999-133625A (JP-H11-133625A) and the plate producing device for a photosensitive resin plate of JP2005-208371A, development scum may adhere to the brush during development. However, no countermeasure has been taken against the adhesion of development scum. Therefore, in a case where the development scum adheres to the brush, it is difficult to remove the development scum.

Further, in both JP1999-133625A (JP-H11-133625A) and JP2005-208371A, the brush is caused to rotate, but the brush is not caused to revolve. In this case, the developer may not be sufficiently supplied to the brush, and the development may not always be uniform.

Furthermore, in both JP1999-133625A (JP-H11-133625A) and JP2005-208371A, a development target is developed in a state in which the development target is fixed. A circumferential speed is different between a center and an outer edge of the rotating brush, and a development speed is also different therebetween. For this reason, it is not always possible to make the development uniform.

However, in both JP1999-133625A (JP-H11-133625A) and JP2005-208371A, the development target is developed in a state in which the development target is fixed as described above, but it is considered to transport the development target in order to increase the development speed. However, JP1999-133625A (JP-H11-133625A) and JP2005-208371A do not consider transporting the developing target. Moreover, since the brush that rotates has a different circumferential speed depending on a location as described above, it is difficult to develop uniformly by simply transporting the development target, and it is difficult to achieve both the development speed and a development uniformity.

As described above, at present, there is no product that can achieve prevention of development scum adhesion, development uniformity, and development speed at the same time.

An object of the present invention is to provide a washing device and a washing method that solve the above-mentioned problems based on the related art and achieve prevention of development scum adhesion, development uniformity, and development speed at the same time.

In order to achieve the object, a washing device according to independent claim 1 and/or a washing method according to independent claim 14 is provided. Distinct embodiments are derivable from the dependent claims.

According to the present invention, it is possible to provide a washing device that achieves prevention of development scum adhesion, development uniformity, and development speed at the same time. Also, it is possible to provide a washing method that can achieve prevention of development scum adhesion, development uniformity, and development speed at the same time.

### BRIEF DESCRIPTION OF THE DRAWINGS

Fig. 1 is a schematic view showing a first example of a washing device according to an embodiment of the present invention.
Fig. 2 is a schematic view showing an arrangement of a brush of the first example of the washing device according to the embodiment of the present invention.
Fig. 3 is a schematic perspective view showing a configuration of the brush of the first example of the washing device according to the embodiment of the present invention.
Fig. 4 is a schematic view showing a configuration of the brush of the first example of the washing device according to the embodiment of the present invention.
Fig. 5 is a schematic view showing another example of a developing section of the first example of the washing device according to the embodiment of the present invention.
Fig. 6 is a schematic view showing another example of the developing section of the first example of the washing device according to the embodiment of the present invention.
Fig. 7 is a schematic view showing still another example of the developing section of the first example of the washing device according to the embodiment of the present invention.
Fig. 8 is a schematic view showing still another example of the developing section of the first example of the washing device according to the embodiment of the present invention.
Fig. 9 is a schematic view showing still another example of the developing section of the first example of the washing device according to the embodiment of the present invention.
Fig. 10 is a schematic view showing still another example of the developing section of the first example of the washing device according to the embodiment of the present invention.
Fig. 11 is a schematic view showing still another example of the developing section of the first example of the washing device according to the embodiment of the present invention.
Fig. 12 is a schematic view showing still another example of the developing section of the first example of the washing device according to the embodiment of the present invention.
Fig. 13 is a schematic view showing a second example of the washing device according to the embodiment of the present invention.
Fig. 14 is a schematic view showing a developing section of the second example of the washing device according to the embodiment of the present invention.
Fig. 15 is a schematic view showing another example of the developing section of the second example of the washing device according to the embodiment of the present invention.
Fig. 16 is a schematic view showing still another example of the developing section of the second example of the washing device according to the embodiment of the present invention.
Fig. 17 is a schematic cross-sectional view showing a brush which is used in the developing section of the washing device according to the embodiment of the present invention.
Fig. 18 is a schematic view showing an example of a supply form of washing solution of the washing device according to the embodiment of the present invention.

### DESCRIPTION OF THE PREFERRED EMBODIMENTS

Hereinafter, a washing device and a washing method according to an embodiment of the present invention will be described in detail based on the preferred embodiments shown in the accompanying drawings.

In addition, the drawings described below are illustrations for describing the present invention, and the present invention is not limited to the drawings shown below.

In the following, "to" indicating a numerical range includes numerical values on both sides. For example, in a case where ε is a numerical value α to a numerical value β, the range of ε is a range including the numerical value α and the numerical value β, and it is expressed as α ≤ ε ≤ β in mathematical symbols.

In addition, regarding "orthogonal" or a specific angle, unless otherwise specified, an error range generally allowed in the corresponding technical field is included. Furthermore, regarding numerical values and the like, unless otherwise specified, an error range generally allowed in the corresponding technical field is included.

### (First example of washing device)

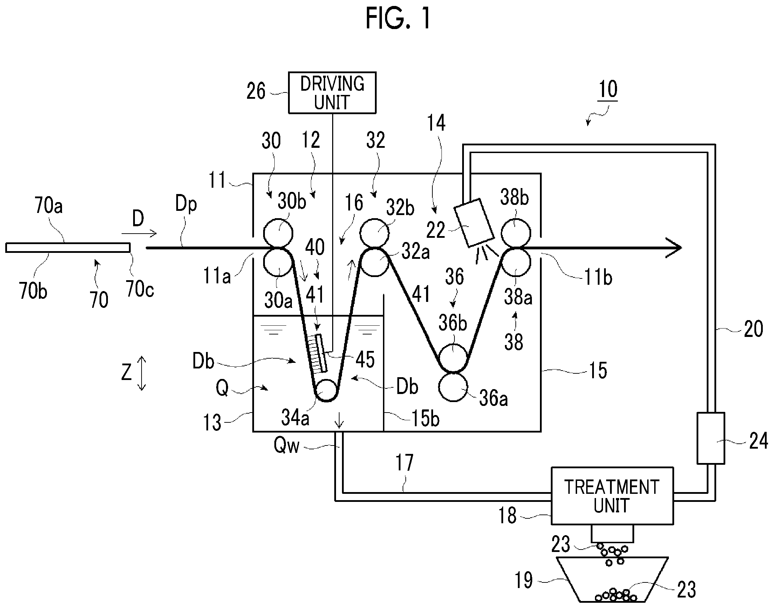

Fig. 1 is a schematic view showing a first example of the washing device according to the embodiment of the present invention.

A washing device 10 shown in Fig. 1 is a transport type washing device that develops a flexographic printing plate precursor 70 after imagewise exposure, which is exposed imagewise on a surface 70a, using a washing solution Q, while transporting the flexographic printing plate precursor 70, and that performs the development in a state in which the flexographic printing plate precursor 70 is transported along a predetermined transport path. Performing development using the above-described washing solution Q is called a development step. Reference Dp in Fig. 1 indicates a transport path of the flexographic printing plate precursor 70.

As will be described later, the flexographic printing plate precursor 70 is as thin as several millimeters, and is flexible enough to be transported serpentinely in a developing tank 13. In addition, the imagewise exposure to the surface 70a of the flexographic printing plate precursor 70 is performed using, for example, an exposure device (not shown). The imagewise exposed surface 70a of the flexographic printing plate precursor 70 is a printing surface.

In the washing device 10, on the flexographic printing plate precursor 70 after imagewise exposure in a state in which the flexographic printing plate precursor 70 is immersed in the washing solution Q and transported, an unexposed portion (not shown) of the flexographic printing plate precursor 70 is removed and development is performed. The washing device 10 is not a device that performs development by batch processing, but is a single sheet type device that performs development while transporting the flexographic printing plate precursor 70 along the predetermined transport path. In the washing method using the washing device 10, development is performed while transporting the flexographic printing plate precursor 70 along the predetermined transport path. The washing method is a developing method.

The above-described expressions of "while transporting the flexographic printing plate precursor 70" and the "state in which the flexographic printing plate precursor 70 is transported" refer to that the flexographic printing plate precursor 70 is moved along the transport path Dp.

The washing device 10 has a developing section 12 and a rinsing section 14. For example, the developing section 12 and the rinsing section 14 are provided side by side in one housing 11, the developing section 12 is arranged on an inlet 11a side of the housing 11, and the rinsing section 14 is arranged on an outlet 11b of the housing 11. Further, the washing device 10 has a treatment unit 18 provided in the developing tank 13 through a connection pipe 17.

The developing section 12 of the washing device 10 has the developing tank 13, and a transport unit 16 which transports the flexographic printing plate precursor 70 through a transport path Dp including a curved transport path Db. The developing tank 13 is a container in which the washing solution Q is stored.

The transport unit 16 transports the flexographic printing plate precursor 70 through the transport path Dp including the curved transport path Db as described above, and has a pair of first transport rollers 30 arranged on an upstream side in a transporting direction D in which the flexographic printing plate precursor 70 is transported, and a pair of second transport rollers 32 arranged on a downstream side in the transporting direction D. The pair of first transport rollers 30 and the pair of second transport rollers 32 are provided, for example, above the developing tank 13 at the same height.

By the transport unit 16, the flexographic printing plate precursor 70 is transported in the developing tank 13 in a state of being immersed in the washing solution Q.

The upstream side in the transporting direction D is the inlet 11a side of the housing 11, and the downstream side in the transporting direction D is the outlet 11b side of the housing 11.

The pair of first transport rollers 30 has a roller 30a arranged on a back surface 70b side of the flexographic printing plate precursor 70 and a roller 30b arranged on the surface 70a side of the flexographic printing plate precursor 70, and transports the flexographic printing plate precursor 70 with the flexographic printing plate precursor 70 interposed therebetween. One of the roller 30a and the roller 30b described above is a driving roller and the other is a driven roller.

Similarly to the pair of first transport rollers 30, the pair of second transport rollers 32 has a roller 32a arranged on the back surface 70b side of the flexographic printing plate precursor 70 and a roller 32b arranged on the surface 70a side of the flexographic printing plate precursor 70, and transports the flexographic printing plate precursor 70 with the flexographic printing plate precursor 70 interposed therebetween. One of the roller 32a and the roller 32b described above is a driving roller and the other is a driven roller.

### (Transport unit)

The transport unit 16 has a guide roller 34a which is arranged between the pair of first transport rollers 30 and the pair of second transport rollers 32 and in the developing tank 13, and guides the flexographic printing plate precursor 70. The flexographic printing plate precursor 70 is transported by the guide roller 34a by turning once in the developing tank 13. The number of guide rollers is appropriately determined according to the size of the developing tank 13, the size of the flexographic printing plate precursor 70, and the like. Further, the number of turns of the flexographic printing plate precursor 70 is not limited to one, and the number of turns may be multiple.

Curving and transporting the flexographic printing plate precursor 70 like the transport path Db to immerse the flexographic printing plate precursor 70 in the washing solution Q in the developing tank 13 is referred to as curvedly transporting the flexographic printing plate precursor 70.

As the guide roller 34a, for example, it is preferable to use a rubber roller, a sponge roller, or the like so as not to damage the printing surface, that is, the surface 70a of the flexographic printing plate precursor 70.

Regarding the transport path Dp of the flexographic printing plate precursor 70, there are various transport paths such as a one-way transport path, a round-trip transport path, and a circumferential transport path. However, it is preferable that the transport path Dp of the flexographic printing plate precursor 70 is the one-way transport path in that a plurality of the flexographic printing plate precursors 70 can be continuously processed.

### (Development unit)

In addition, the washing device 10 comprises a development unit 40 that performs development on the flexographic printing plate precursor 70 in a state in which the flexographic printing plate precursor 70 is immersed in the washing solution Q in the developing tank 13 and transported.

In the developing section 12, a development fatigue liquid Qw is generated in the developing tank 13 by development by the development unit 40. The development fatigue liquid Qw is the washing solution Q including solids generated by removing an unexposed portion (not shown) of the flexographic printing plate precursor 70 by the development using the washing solution Q.

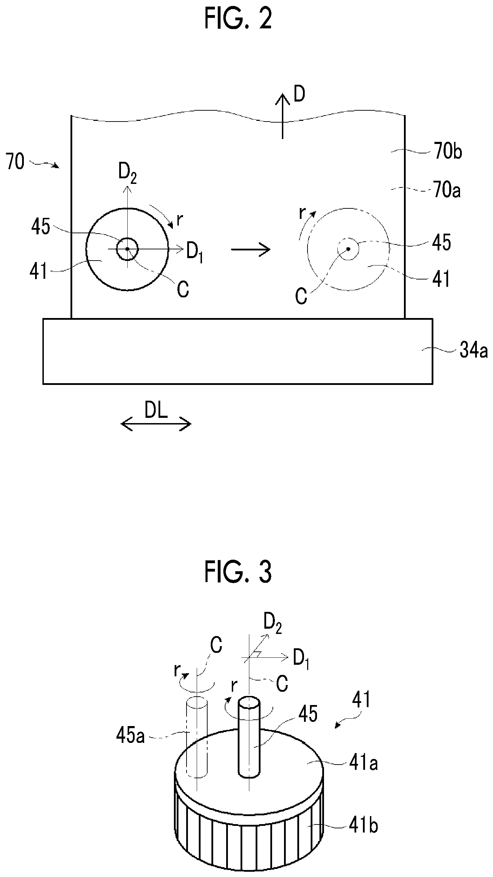

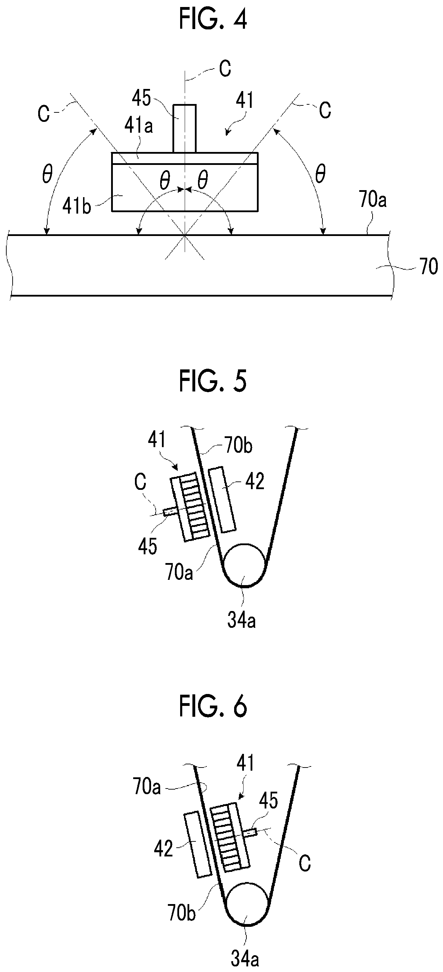

Here, Fig. 2 is a schematic view showing an arrangement of a brush of the first example of the washing device according to the embodiment of the present invention. Fig. 3 is a schematic perspective view showing a configuration of the brush of the first example of the washing device according to the embodiment of the present invention. Fig. 4 is a schematic view showing a configuration of the brush of the first example of the washing device according to the embodiment of the present invention.

The development unit 40 includes a brush 41 which is used for the development and a driving unit 26 which controls rotation of the brush 41 around a rotation axis C (see Fig. 3) and movement of the brush 41.

The above-described rotation of the brush 41 around the rotation axis C refers to that the brush 41 rotates about the rotation axis C as the center of the rotation, and the brush 41 revolves. The rotation axis C is a fixed axis that passes through one point in the brush 41. The brush 41 is provided with a rotating shaft portion 45, and a central axis of the rotating shaft portion 45 is the rotation axis C. The rotating shaft portion 45 functions as a rotary drive shaft that rotates by power transmitted from the driving unit 26, and the brush 41 can revolve, for example, in a rotation direction r (see Fig. 2) by rotating the rotating shaft portion 45.

The driving unit 26 rotates the brush 41 in a state in which the rotation axis C of the brush 41 passes through the surface 70a of the flexographic printing plate precursor 70 (see Fig. 4). In addition, the driving unit 26 moves the rotation axis C of the brush 41 in at least one direction intersecting the rotation axis C. Unless otherwise specified, the rotation of the brush 41 and the movement of the brush 41 are controlled by the driving unit 26.

As shown in Fig. 2, the brush 41 is arranged on the surface 70a side of the flexographic printing plate precursor 70, and as a first movement direction D₁ of the brush 41 intersecting the rotation axis C, for example, a direction DL orthogonal to the transporting direction D is set. The brush 41 is configured to move in the direction DL. Further, the brush 41 may be configured to move in two directions with respect to the rotation axis C. In a case where moving in two directions, there is no limitation as long as the brush 41 moves in two directions, and the two directions may intersect the rotation axis C or the two directions may be orthogonal to the rotation axis C. Specifically, for example, the first movement direction D₁ is the direction DL, and a second movement direction D₂ is the transporting direction D. As long as the brush 41 can evenly rub an entire surface 70a of the flexographic printing plate precursor 70, the movement direction of the brush 41 is not particularly limited. In a case where the brush 41 is configured to move in orthogonal two directions, the brush 41 can evenly rub the entire surface 70a of the flexographic printing plate precursor 70 to improve the development uniformity. Furthermore, the development speed is also improved by moving the brush 41 in orthogonal two directions.

### <Brush>

The brush 41 develops by removing an unexposed portion (not shown) of the flexographic printing plate precursor 70. The brush 41 is, for example, immersed in the washing solution Q and arranged on the surface 70a side of the flexographic printing plate precursor 70 in the transporting direction D in the developing tank 13. In a state in which the flexographic printing plate precursor 70 is transported, the surface 70a of the flexographic printing plate precursor 70 is rubbed with the brush 41 rotated in a rotation direction r (see Fig. 2) by the driving unit 26, the unexposed portion (not shown) of the flexographic printing plate precursor 70 is removed, and development is performed. The above development fatigue liquid Qw is generated during this development.

Since the brush 41 is immersed in the washing solution Q and arranged, the washing solution Q adhering to the brush 41 is not dried, and the unexposed portion removed by the brush 41 or the like is prevented from being fixed to the brush 41 as development scum.

Brush 41, as shown in Fig. 2, an area of the brush 41 which is projected on the surface 70a of the flexographic printing plate precursor 70 is smaller than an area of the surface 70a of the flexographic printing plate precursor 70. Therefore, the development is performed by the brush 41 partially applied to the entire width of the flexographic printing plate precursor 70. During development, since the brush 41 is small, the brush 41 moves, for example, in the transporting direction D and the direction DL as described above in order to apply the brush 41 to evenly rub the entire surface 70a of the flexographic printing plate precursor 70, and may be configured to move only in the direction DL.

The movement path of the brush 41 is determined in advance according to the size of the brush 41, the size of the flexographic printing plate precursor 70, the transport speed, and the like. As a result, the movement path of the brush 41 can be programmed and development can be performed based on the program.

As shown in Fig. 3, the brush 41 has, for example, a bunch of bristles 41b perpendicular to a substrate 41a. A shape of the substrate 41a is the shape of the brush 41. The substrate 41a is, for example, circular, and is not particularly limited.

A rotating shaft portion 45 is provided on the substrate 41a. As a result, the rotation axis C is provided in the brush 41. In addition, by adjusting a position where the rotating shaft portion 45 is provided, the position of the rotation axis C can be adjusted in the brush 41. As shown in Fig. 3, the rotating shaft portion 45a can be provided at a location other than the center of the substrate 41a.

Here, the center of the brush 41 is the center of the substrate 41a of the brush 41, that is, a geometric center of the shape of the substrate 41a projected onto a plane. In a case where the substrate 41a is circular, the center of the circle will be the center of the brush 41. In a case where the substrate 41a is rectangular, a point where the diagonals of a rectangle intersects will be the center of the brush 41.

The rotation axis C of the brush 41 passing through the center of the brush 41 refers to that in a case where the substrate 41a is circular, the rotating shaft portion 45 is arranged so that the rotation axis C passes through the center of the substrate 41a. By arranging the rotation axis C so as to pass through the center of the brush 41, the brush 41 can be uniformly brought into contact with the surface 70a of the flexographic printing plate precursor 70. Therefore, the development uniformity is improved.

Further, by arranging the rotation axis C so as to pass through the center of the brush 41, in a case where the brush 41 is caused to revolve, the brush 41 rotates stably. Therefore, it is possible to rotate the brush 41 stably even in a case of increasing the rotation speed in order to increase the rotating speed of the brush 41. As a result, the development speed can be increased.

Further, in a case where a plurality of the brushes 41 are arranged in parallel, a contact of the brushes 41 can be suppressed even in a case where a distance between the brushes 41 is reduced. For this reason, it is preferable that the rotation axis C of the brush 41 passes through a center of the brush 41.

As the brush 41, for example, a brush called a cup brush is used. It is preferable that the bristles 41b of the brush 41 are used by being applied substantially perpendicularly to the surface 70a of the flexographic printing plate precursor 70.

As described above, the brush 41 is smaller than the flexographic printing plate precursor 70. Since the brush 41 is small, the brush 41 is moved with respect to the flexographic printing plate precursor 70 to perform development, pressure of the brush 41 can be made uniform, and the development uniformity can be improved.

Further, by performing development by moving the brush 41 in a plane direction while transporting the flexographic printing plate precursor 70, a brush area required for the development can be reduced, and therefore the washing device can be simplified.

A size of the brush 41 is not particularly limited as long as the size is smaller than the flexographic printing plate precursor 70. In a case where an outer shape of the substrate 41a of the brush 41 is circular, a diameter is preferably 30 mm to 500 mm, more preferably 100 to 400 mm, and most preferably 200 to 400 mm.

In a case where the shape of the substrate 41a of the brush 41 has a brush shape other than the circle, an equivalent circle diameter, that is, a diameter of the shape having a size corresponding to the brush area is defined as a diameter in a case where the outer shape of the substrate 41a is a circle.

In addition, the brush 41 is rotated to develop, and the rotation speed of the brush 41 is preferably 10 rpm (revolutions per minute) to 2000 rpm, and more preferably 100 to 800 rpm.

By increasing the rotation speed of the brush 41 to increase the rotating speed thereof, the development speed can be increased as described above, and the development uniformity is also improved.

Here, regarding a mechanism of the development scum adhesion, it is presumed that the development scum is deposited in the brush 41 during development and transferred to the flexographic printing plate precursor 70 at a certain timing, and the development scum adheres. Therefore, it is necessary to efficiently discharge the development scum from the inside of the brush 41 to the outside of the brush 41. Therefore, in a case where rotation speed of the brush 41 is high, the washing solution in the brush 41 is easily discharged to the outside of the brush 41 due to the rotation, and the development scum in the brush 41 can be efficiently discharged to the outside of the brush 41.

Further, the rotation speed of the brush 41 is not limited to a fixed value, and may be variable. In a case where the rotation speed of the brush 41 can be changed, for example, the rotation speed is determined in advance from an initial stage of development to the end of development, and development can be performed at a determined rotation speed.

The substrate 41a of the brush 41 holds the bristles 41b and is, for example, implanted in a bundle. The substrate 41a is not particularly limited as long as the substrate can hold the bristles 41b and is not deteriorated by the washing solution Q.

A material of the bristles of the brush 41 is not particularly limited. For example, natural fibers such as shroud, metals, polyamides, polyesters, vinyl chlorides, vinylidene chlorides, polyimides, polyacrylonitrile, and the like, which can be made into fibers can be suitably used.

A fiber diameter of the bristles of the brush is preferably about 10 µ to 1 mm, and may be implanted in a bundle or may be independently implanted within several brushes. An implanting interval is preferably about 1 to 20 mm, and in a case where the bristles are implanted in a bundle, the diameter of the bundle is preferably about 1 to 10 mm. In addition, the length of the bristles of the brush is preferably about 2 to 50 mm.

The length of the bristles may be different in one brush 41, and it is preferable that the bristles in the central portion are long. Further, the thickness of the bristles may be different in one brush 41, and the density of bristles may be different in one brush 41.

As described above, the brush 41 is rotated by the driving unit 26 in a state in which the rotation axis C of the brush 41 passes through the surface 70a of the flexographic printing plate precursor 70 (see Fig. 4). In this case, as shown in Fig. 4, in a case where an angle formed by the rotation axis C with respect to the surface 70a of the flexographic printing plate precursor 70 is θ, the angle θ is preferably 30° ≤ θ ≤ 90°, more preferably 45° ≤ θ ≤ 90°, and most preferably 60° ≤ θ ≤ 90°. By setting the angle θ to 60° ≤ θ ≤ 90°, the brush 41 can be uniformly contacted with the surface 70a of the flexographic printing plate precursor 70, and the development can be performed even in a case where the pressure of the brush 41 is increased. Therefore, it is possible to achieve both development uniformity and development speed. As described above, it is most preferable that the rotation axis C of the brush 41 is perpendicular to the surface 70a of the flexographic printing plate precursor 70.

The angle θ can be obtained as follows. First, an image in a state in which the brush 41 is arranged on the surface 70a of the flexographic printing plate precursor 70 is acquired, and a line corresponding to the rotation axis C of the brush 41 from the image and a line corresponding to the surface 70a of the flexographic printing plate precursor 70 are obtained from the image. Next, the angle formed by these two lines is obtained. As a result, the angle θ can be obtained.

The state in which the rotation axis C of the brush 41 passes through the surface 70a of the flexographic printing plate precursor 70 refers to that in a case of the rotation axis C or in a case where the rotation axis C is extended, the rotation axis C passes through the surface 70a of the flexographic printing plate precursor 70 or through a face obtained by expanding the surface 70a of the flexographic printing plate precursor 70, and shows an arrangement relationship between the brush 41 and the flexographic printing plate precursor 70.

Therefore, depending on the inclination of the rotation axis C, the rotation axis C of the brush 41 may not pass through the surface 70a of the actual flexographic printing plate precursor 70, but the rotation axis C of the brush 41 is not limited to actually passing through the surface 70a of the flexographic printing plate precursor 70 as described above.

A position of the brush 41 with respect to the surface 70a of the flexographic printing plate precursor 70 may be fixed. Further, a configuration close to or spaced from the surface 70a of the flexographic printing plate precursor 70 may be adopted. Since the brush 41 can be close to or spaced from the surface 70a of flexographic printing plate precursor 70, it is possible to adjust the pressure of the brush 41 to the surface 70a of flexographic printing plate precursor 70. As a result, the pressure of the brush 41 can be increased, and the development speed can be improved.

In a case where the pressure of the brush 41 is increased, it is preferable that the material of the bristles 41b of the brush 41, the length of the bristles, the thickness of the bristles, and the like are set to correspond to the pressure. The bristle in a central portion in one brush may be lengthened, the thickness of the bristle in one brush 41 may be changed, or the density of the bristles in one brush 41 may be changed.

Further, since the brush 41 can be spaced from the surface 70a of flexographic printing plate precursor 70, it is possible to lift the brush 41 from the surface 70a of flexographic printing plate precursor 70. As a result, in a case where the development scum of the brush 41 adheres, the development scum can be removed from the brush 41.

Regarding the operation of the brush 41, the brush 41 may be constantly moved during development, or the brush 41 may be rotated only in a case where the flexographic printing plate precursor 70 is transported to the developing tank 13. In this case, for example, it is possible to perform development by providing a sensor for detecting the flexographic printing plate precursor 70 in the pair of first transport roller pairs 30, and specifying the time to reach the brush 41 by using the transport timing and transport speed of the flexographic printing plate precursor 70 to rotate the brush 41.

Further, for example, an outside of the flexographic printing plate precursor 70, an upper part of the surface 70a of flexographic printing plate precursor 70 can be used as a retraction site of the brush 41. The brush 41 is moved to the retraction site by the driving unit 26, and the driving unit 26 retracts the brush 41 from the flexographic printing plate precursor 70. By retracting the brush 41 from the flexographic printing plate precursor 70, adhesion of development scum is suppressed, which is preferable.

In a case where the outside of the flexographic printing plate precursor 70 is used as the retraction site, the development scum is less likely to adhere to the surface 70a of the flexographic printing plate precursor 70 again as compared with the case where the brush 41 is simply lifted from the surface 70a of the flexographic printing plate precursor 70 and retracted, and the adhesion of the development scum can further be suppressed.

In a case of removing development scum, retraction conditions such as development time or a development processing area are set rather than moving the brush 41 to the retraction site, and in a case where the retraction conditions are satisfied, the brush 41 may be configured to move to the retraction site. In this case, for example, it is possible to control the retraction of the brush 41 by providing a sensor for detecting the flexographic printing plate precursor 70 in the pair of first transport rollers 30, and setting the retraction conditions for the driving unit 26 and then specifying an input amount of the flexographic printing plate precursor 70 by using the transport timing and the transport speed of the flexographic printing plate precursor 70.

Further, in order to efficiently discharge the development scum inside the brush 41 to the outside of the brush 41, a washing solution may be supplied to the brush 41 at the retraction site of the brush 41 so that the development scum may be discharged to the outside of the brush 41.

### (Rinsing section)

The rinsing section 14 is provided for removing residues such as latex components and rubber components remaining on the surface 70a of the flexographic printing plate precursor 70 after development using a washing solution or the like. In the rinsing section 14, removing residues such as latex components and rubber components remaining on the surface 70a of the flexographic printing plate precursor 70 using a washing solution or the like is called a rinsing step.

The rinsing section 14 has a pair of transport rollers 36 on a downstream side of the pair of second transport rollers 32 in the transporting direction D and in a rinsing tank 15, and a pair of transport rollers 38 that transports the flexographic printing plate precursor 70 to the outlet 11b of the housing 11. The developed flexographic printing plate precursor 70 is transported to the pair of transport rollers 36 from the developing section 12 and transported to the outside of the housing 11 by the pair of transport rollers 38.

The developing tank 13 and the rinsing tank 15 are provided adjacent to each other, and in the rinsing tank 15, a side wall 15b is formed to be higher than the liquid level of the washing solution Q in the developing tank 13 so that the washing solution Q in the developing tank 13 is prevented from entering the rinsing tank 15.

For example, the rinsing section 14 has a supply unit 22 that supplies the development fatigue liquid Qw treated by the treatment unit 18 to the surface 70a of the flexographic printing plate precursor 70. The development fatigue liquid Qw treated by the treatment unit 18 is supplied to the supply unit 22 through a pipe 20.

In the rinsing section 14, for example, between the pair of transport rollers 36 and the pair of transport rollers 38, the development fatigue liquid Qw treated by the treatment unit 18 is applied to the surface 70a of the flexographic printing plate precursor 70 after development as a washing solution Q from the supply unit 22 to be sprayed onto the surface 70a of the flexographic printing plate precursor 70, for example, and thus the above residues are washed. The development fatigue liquid Qw from the supply unit 22 and the above washed residues are accumulated in rinsing tank 15.

The washing solution Q to be supplied may be a washing solution Q newly produced in another tank (not shown). The development fatigue liquid Qw accumulated in the rinsing tank 15 can be reused as a washing solution Q by being transferred to the developing tank 13. For the liquid transfer method, for example, a pump can be used. Moreover, a configuration in which the accumulated development fatigue liquid Qw is naturally supplied to the developing tank 13 across the side wall 15b may be adopted.

The pair of transport rollers 36 described above has a roller 36a arranged on the back surface 70b side of the flexographic printing plate precursor 70 and a roller 36b arranged on the surface 70a side of the flexographic printing plate precursor 70, and transport the flexographic printing plate precursor 70 with the flexographic printing plate precursor 70 interposed therebetween.

The pair of transport rollers 38 has a roller 38a arranged on the back surface 70b side of the flexographic printing plate precursor 70 and a roller 38b arranged on the surface 70a side of the flexographic printing plate precursor 70, and transport the flexographic printing plate precursor 70 with the flexographic printing plate precursor 70 interposed therebetween.

For example, both the roller 36a and the roller 36b described above are driven rollers. For example, one of the rollers 38a and 38b is a driving roller, and the other is a driven roller.

### (Treatment unit)

The treatment unit 18 removes solids 23 in the development fatigue liquid Qw including the solids 23 generated by removing the unexposed portion by the development using the washing solution Q. In addition, the development fatigue liquid Qw containing the solids 23 means a state in which the solids 23 are dissolved or dispersed.

In addition, the treated development fatigue liquid Qw means that the solids 23 included in the development fatigue liquid Qw are removed.

In the treatment unit 18, the solids 23 removed from the development fatigue liquid Qw are collected by a tray 19 provided below the treatment unit 18.

On the other hand, the development fatigue liquid Qw from which the solids 23 are removed, that is, the above treated development fatigue liquid Qw is supplied to the supply unit 22 through the pipe 20 and used in the rinsing section 14. For example, a pump (not shown) is used to supply the development fatigue liquid Qw treated from the treatment unit 18 to the supply unit 22.

Since the development fatigue liquid Qw can be reused by providing the treatment unit 18, the washing solution Q can be used effectively and the utilization efficiency of the washing solution Q can be increased.

As long as the treatment unit 18 can remove the solids 23 from the development fatigue liquid Qw as described above, the configuration thereof is not particularly limited and is formed of, for example, a centrifuge.

In addition, a separation membrane 24 which removes the solids 23 in the development fatigue liquid Qw may be provided in the pipe 20. The separation membrane 24 is not particularly limited as long as the membrane can separate the solids included in the development fatigue liquid Qw, and is appropriately determined depending on the size of the solid matter to be separated, and for example, a ceramic filter is used. For example, the separation membrane 24 is preferably capable of separating a solid having a particle size of 1 µm or less.

The separation membrane 24 is not necessarily required and may be omitted. However, a case where the development fatigue liquid Qw is allowed to pass through the separation membrane 24 is preferable since the concentration of the solids of the development fatigue liquid Qw supplied to the rinsing section 14 can be further reduced and a development fatigue liquid Qw having a low solid concentration can be used in the rinsing section 14.

In addition, the separation membrane 24 may be used as the treatment unit 18. In this case, for example, only the separation membrane 24 is provided without providing the above-described centrifuge.

The treatment unit 18 is not necessarily required and a configuration without the treatment unit 18 may be used. In this case, for example, the washing solution Q is used in the rinsing section 14.

Here, as the concentration of the solids of the development fatigue liquid Qw increases, more development scum is fixed and the device is more easily contaminated. Accordingly, as the concentration of the solids of the development fatigue liquid Qw decreases, the contamination of the device can be more suppressed, and thus the maintainability is excellent. Therefore, it is preferable to provide the treatment unit 18 that removes the solids.

### (Washing method)

Next, a washing method for the flexographic printing plate precursor 70 using the washing device 10 will be described.

First, an exposure device (not shown) exposes the surface 70a of the flexographic printing plate precursor 70 with imagewise exposure, that is, a specific pattern.

Next, the flexographic printing plate precursor 70 after imagewise exposure is transported to the washing device 10. In the washing device 10, the flexographic printing plate precursor 70 is transported along the predetermined transport path, allowed to pass through the inlet 11a of the housing 11 and is transported into the washing solution Q by the guide roller 34a of the developing tank 13 through the pair of first transport rollers 30. At this time, in a state in which the flexographic printing plate precursor 70 is immersed in the washing solution Q and transported, development is performed by removing the unexposed portion of the flexographic printing plate precursor 70 by the brush 41 of the development unit 40. In the development step of performing the development, the brush 41 is rotated while transporting the flexographic printing plate precursor 70 in a state in which the rotation axis C of the brush 41 passes through the surface 70a of the flexographic printing plate precursor 70 as described above. The rotation axis C of the brush 41 is moved in at least one direction intersecting the rotation axis C. Since the operation of the brush 41 is as described above, detailed description thereof will be omitted.

In the development step, the development fatigue liquid Qw is generated. Then, the flexographic printing plate precursor 70 is transported to the pair of transport rollers 36 and the pair of transport rollers 38 of the rinsing tank 15 through the pair of second transport rollers 32. In a state in which the flexographic printing plate precursor 70 is transported, the development fatigue liquid Qw treated by the treatment unit 18 is applied to the surface 70a of the flexographic printing plate precursor 70 by the supply unit 22, and the residues on the surface 70a are removed. Then, the flexographic printing plate precursor 70 is transported from the pair of transport rollers 38 to the outside through the outlet 11b of the housing 11.

As in the washing device 10, by performing the development step in a state in which the flexographic printing plate precursor 70 is being transported, the development processing amount per unit time can be increased as compared to batch processing, and thus high productivity is obtained. In addition, by curving and transporting the flexographic printing plate precursor 70, even in a case where the transport path Dp is longer, the size of the actual developing section 12 is not increased and space-saving can be achieved. Further, by developing the flexographic printing plate precursor 70 in the washing solution Q, development scum is prevented from being fixed to the brushes 41, and the frequency of maintenance can be reduced. Thus, the maintenance load can be reduced and maintainability is excellent. In this manner, it is possible to achieve both maintainability and productivity.

Since the frequency of maintenance can be reduced, for example, the monthly or yearly average development processing can be increased, and the washing device 10 has high productivity in this viewpoint.

### (Other configurations of transport unit and development unit)

The configurations of the transport unit 16 and the development unit 40 are not limited to those described above, and may be other configurations.

Here, Figs. 5 to 9 are schematic views showing other examples of the developing section of the first example of the washing device according to the embodiment of the present invention. In Figs. 5 to 9, the same components as those of the washing device 10 shown in Fig. 1 are denoted by the same reference numerals, and detailed description thereof is omitted.

In the configurations of the transport unit 16 and the development unit 40 of the washing device 10, for example, as shown in Figs. 5 and 6, a configuration in which supports 42 that support the flexographic printing plate precursor 70 are provided at positions opposite to the brushes 41 with the flexographic printing plate precursor 70 interposed therebetween may be adopted. Since the flexographic printing plate precursor 70 has flexibility as described above, there is a possibility that the unexposed portion may not be efficiently removed by the brushes 41 due to, for example, bending in a case where the flexographic printing plate precursor 70 is rubbed against the brushes 41. However, by providing the supports 42, the back surface 70b of the flexographic printing plate precursor 70 is supported by the supports 42 in a case where the unexposed portion is removed by the brushes 41 and thus the unexposed portion can be efficiently removed. In addition, the support 42 functions as a transport guide for the flexographic printing plate precursor 70, and the flexographic printing plate precursor 70 can be transported more stably.

The support 42 preferably has strength not to be deformed by brush pressure, heat resistance, and rust resistance that does, and the material of the support 42 is preferably, for example, stainless steel or plastic.

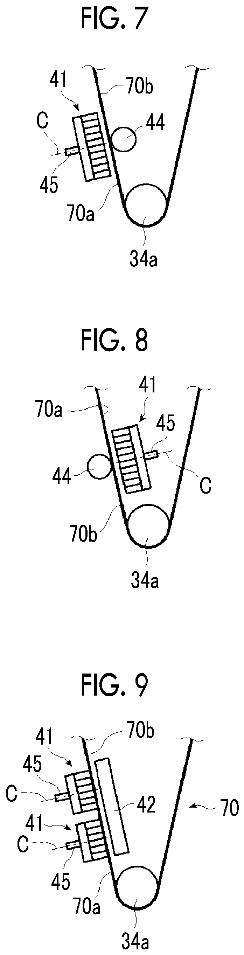

In addition, instead of the supports 42 shown in Figs. 5 and 6, as shown in Figs. 7 and 8, guide rollers 44 may be provided in contact with the back surface 70b of the flexographic printing plate precursor 70. In this case, similar to the supports 42 shown in Figs. 5 and 6, since the back surface 70b of the flexographic printing plate precursor 70 is supported by the guide roller 44 in a case where the unexposed portion is removed by the brushes 41, the unexposed portion can be efficiently removed. In addition, the guide roller 44 functions as a transport guide for the flexographic printing plate precursor 70, and the flexographic printing plate precursor 70 can be transported more stably.

The number of brushes 41 provided in the development unit 40 is not limited to one, and may be plural. For example, as shown in Fig. 9, a configuration having two brushes 41 may be adopted.

In this case, a plurality of brushes, or two brushes 41 in Fig. 9, can be used for development at the same time. As a result, an area rubbed by the brush 41 is increased, and the development speed can be increased in a state in which the adhesion of development scum is suppressed and the development uniformity is maintained. In this case, the rotating speed of the plurality of brushes 41 may be the same, or the rotating speed may be changed for each brush 41. In a case where the rotating speed of the brushes 41, the size of the brush 41 is changed or the rotation speed of the brush 41 is changed.

In a case where a plurality of brushes are provided, for example, one motor may drive at least two brushes at the same time instead of rotating each brush individually. As a result, the number of motors can be reduced and the device can be miniaturized. Further, in a case where a plurality of brushes are rotated by one motor, the rotation speed can be changed for each brush 41 by providing a transmission.

The configuration of the development unit 40 of the developing section 12 is not limited to the above-described configuration, and may be a configuration shown below.

The driving unit 26 (see Fig. 1) is connected to a driving shaft portion 27 that rotates as described later. A shaft joint unit 80 that connects the driving shaft portion 27 of the driving unit 26 and the rotating shaft portion 45 of the brush 41 so as to transmit a rotational force of the driving shaft portion 27 of the driving unit 26 to the rotation axis C of the brush 41 and adjusts an inclination of the rotation axis C of the brush 41 with respect to the surface 70a of the flexographic printing plate precursor 70 is provided. The inclination of the rotation axis C of the brush 41 is adjusted by the shaft joint unit 80 so that a tip surface 41c of the brush 41 is arranged parallel to the surface 70a of the flexographic printing plate precursor 70.

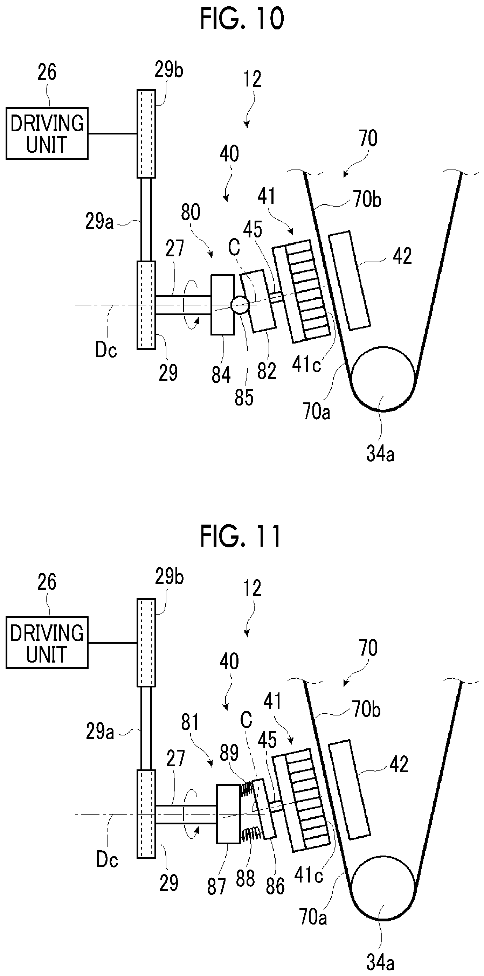

The shaft joint unit 80 shown in Fig. 10 is called a ball joint. In the shaft joint unit 80, a first member 82 and a second member 84 are connected via a ball 85. The ball 85 allows the first member 82 and the second member 84 to move relatively, and can transmit rotation between the first member 82 and the second member 84.

The first member 82 is connected to the rotating shaft portion 45 of the brush 41. The second member 84 is connected to the driving shaft portion 27. The driving shaft portion 27 is provided with, for example, a first pulley 29 at the opposite end of the second member 84. A second pulley 29b is arranged so as to face the first pulley 29, and a transmission belt 29a is wound around the first pulley 29 and the second pulley 29b. The driving unit 26 is connected to the second pulley 29b. In a case where the second pulley 29b is rotated by the driving unit 26, the first pulley 29 is rotated to rotate the driving shaft portion 27, and the rotational force of the driving shaft portion 27 is transmitted to the rotating shaft portion 45 via the shaft joint unit 80, and the brush 41 rotates.

As described above, since the first member 82 and the second member 84 are relatively moved by the ball 85, the inclination of the rotation axis C of the rotating shaft portion 45 of the brush 41 with respect to the surface 70a of the flexographic printing plate precursor 70 can be changed. As a result, a direction of the tip surface 41c of the brush 41 can be changed, and the tip surface 41c of the brush 41 can be arranged parallel to the surface 70a of the flexographic printing plate precursor 70. As a result, the tip surface 41c of the brush 41 can be developed in a state of being in uniform contact with the surface 70a of the flexographic printing plate precursor 70, and one-sided contact or the like can be suppressed to develop efficiently and even better.

Further, depending on the device configuration, even in a case where the rotation axis C of the brush 41 is inclined as shown in Fig. 10, a driving shaft Dc can be made horizontal by the shaft joint unit 80.

The shaft joint unit 80 is not limited to the configuration shown in Fig. 10, and a universal joint, a flexible coupling, a floating joint, and the like are used. Further, for example, a shaft joint unit 81 shown in Fig. 11 may be used. In Fig. 11, the same components as those shown in Fig. 10 are denoted by the same reference numerals, and detailed description thereof is omitted. The shaft joint unit 81 shown in Fig. 11 has the same function as the shaft joint unit 80 shown in Fig. 10, except that the configuration is different.

The shaft joint unit 81 shown in Fig. 11 has, for example, a first flange 86, a second flange 87, and two elastic members 88 and 89. The first flange 86 and the second flange 87 are arranged so as to face each other, and the two elastic members 88 and 89 are provided between the first flange 86 and the second flange 87. The two elastic members 88 and 89 are, for example, springs.

In the first flange 86 and the second flange 87, the two elastic members 88 and 89 can be displaced independently of each other and move relative to each other.

The first flange 86 is connected to the rotating shaft portion 45 of the brush 41. The second flange 87 is connected to the driving shaft portion 27.

As described above, since the first flange 86 and the second flange 87 are relatively moved by the two elastic members 88 and 89, the inclination of the rotation axis C of the rotating shaft portion 45 of the brush 41 with respect to the surface 70a of the flexographic printing plate precursor 70 can be changed. As a result, a direction of the tip surface 41c of the brush 41 can be changed, and the tip surface 41c of the brush 41 can be arranged parallel to the surface 70a of the flexographic printing plate precursor 70. The tip surface 41c of the brush 41 can be developed in a state of being in uniform contact with the surface 70a of the flexographic printing plate precursor 70, and one-sided contact or the like can be suppressed to develop efficiently and even better.

Further, depending on the device configuration, even in a case where the rotation axis C of the brush 41 is inclined as shown in Fig. 11, a driving shaft Dc can be made horizontal by the shaft joint unit 80.

Further, by providing the two elastic members 88 and 89 in a contracted state as compared with a state in which no force is applied, for example, a force that causes the first flange 86 and the second flange 87 to be relatively separated from each other is received. Accordingly, the first flange 86 is displaced on the surface 70a side of the flexographic printing plate precursor 70, the tip surface 41c of the brush 41 can be pressed against the surface 70a of flexographic printing plate precursor 70. The two elastic members 88 and 89 are not limited to the springs, and may be rubber, elastomer, or the like. The number of the elastic members is not limited to two, and may be one or three or more, and the number of the elastic members is appropriately determined according to the force acting on the brush 41 and the like.

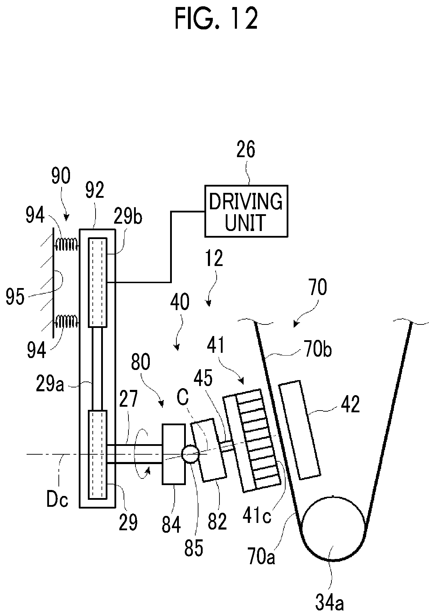

Further, as shown in Fig. 12, the configuration may include a pressing unit 90 that presses the tip surface 41c of the brush 41 against the surface 70a of the flexographic printing plate precursor 70. In Fig. 12, the same components as those shown in Fig. 10 are denoted by the same reference numerals, and detailed description thereof is omitted.

The pressing unit 90 presses, for example, the driving shaft portion 27 against the surface 70a side of the flexographic printing plate precursor 70, and presses the tip surface 41c of the brush 41 against the surface 70a of flexographic printing plate precursor 70.

A transmission belt 29a is wound around the first pulley 29 provided on the driving shaft portion 27 and the second pulley 29b arranged so as to face the first pulley 29. The driving unit 26 is connected to the second pulley 29b, and the driving unit 26 rotates the second pulley 29b. The first pulley 29, the transmission belt 29a, and the second pulley 29b are housed in the case 92. The case 92 is provided with an elastic member 94 on the second pulley 29b side, for example, in a contracted state as compared with a state in which no force is applied. An opposite end portion on an opposite side of the case 92 of the elastic member 94 is fixed to the fixing wall 95. The case 92 is pressed against the flexographic printing plate precursor 70 by the elastic member 94, and the tip surface 41c of the brush 41 is pressed against the surface 70a of the flexographic printing plate precursor 70 via the driving shaft portion 27 and the shaft joint unit 80.

By providing the pressing unit 90 in addition to the shaft joint unit 80, in a state in which the tip surface 41c of the brush 41 is arranged parallel to the surface 70a of flexographic printing plate precursor 70, the tip surface 41c of the brush 41 is pressed against the surface 70a of the flexographic printing plate precursor 70. As a result, the tip surface 41c of the brush 41 can be developed in a state of being uniformly pressed against the surface 70a of the flexographic printing plate precursor 70, and the development can be performed more efficiently and even better.

In Fig. 12, the shaft joint unit 80 shown in Fig. 10 is used, but the present invention is not limited thereto, and the shaft joint unit 81 shown in Fig. 11 can also be used. In addition to this, as described above, the universal joint, the flexible coupling, the floating joint, and the like can be used.

### (Other examples of washing method)

Next, other examples of the washing method for the flexographic printing plate precursor 70 using the washing device 10 will be described.

First, an exposure device (not shown) exposes the surface 70a of the flexographic printing plate precursor 70 with imagewise exposure, that is, a specific pattern.

Next, the flexographic printing plate precursor 70 after imagewise exposure is transported to the washing device 10. In the washing device 10, the flexographic printing plate precursor 70 is transported along the predetermined transport path, allowed to pass through the inlet 11a of the housing 11 and is transported into the washing solution Q by the guide roller 34a of the developing tank 13 through the pair of first transport rollers 30. At this time, in a state in which the flexographic printing plate precursor 70 is immersed in the washing solution Q and transported, development is performed by removing the unexposed portion of the flexographic printing plate precursor 70 by the brush 41 of the development unit 40. In the development step of performing the development, the brush 41 is rotated while transporting the flexographic printing plate precursor 70 in a state in which the rotation axis C of the brush 41 passes through the surface 70a of the flexographic printing plate precursor 70 as described above. The rotation axis C of the brush 41 is moved in at least one direction intersecting the rotation axis C. Since the operation of the brush 41 is as described above, detailed description thereof will be omitted. Furthermore, in the development step, an inclination of the rotation axis of the brush 41 with respect to the surface 70a of the flexographic printing plate precursor 70 is adjusted by the shaft joint unit 80 shown in Fig. 10 and the shaft joint unit 81 shown in Fig. 11 described above, so that a tip surface 41c of the brush 41 is arranged parallel to the surface 70a of the flexographic printing plate precursor 70. As a result, the development can be performed in a state in which the tip surface 41c of the brush 41 can be arranged parallel to the surface 70a of the flexographic printing plate precursor 70.

Further, in addition to the shaft j oint unit 80 shown in Fig. 10 and the shaft j oint unit 81 shown in Fig. 11, the pressing unit 90 shown in Fig. 12 described above causes the tip surface 41c of the brush 41 in the development step, the tip surface 41c of the brush 41 is pressed against the surface 70a of the flexographic printing plate precursor 70. As a result, the development can be performed in a state in which the tip surface 41c of the brush 41 is arranged parallel to the surface 70a of flexographic printing plate precursor 70 and the tip surface 41c of the brush 41 is pressed against the surface 70a of the flexographic printing plate precursor 70.

In the development step, the development fatigue liquid Qw is generated. Then, the flexographic printing plate precursor 70 is transported to the pair of transport rollers 36 and the pair of transport rollers 38 of the rinsing tank 15 through the pair of second transport rollers 32. In a state in which the flexographic printing plate precursor 70 is transported, the development fatigue liquid Qw treated by the treatment unit 18 is applied to the surface 70a of the flexographic printing plate precursor 70 by the supply unit 22, and the residues on the surface 70a are removed. Then, the flexographic printing plate precursor 70 is transported from the pair of transport rollers 38 to the outside through the outlet 11b of the housing 11.

### (Second example of washing device)

Next, a second example of the washing device will be described.

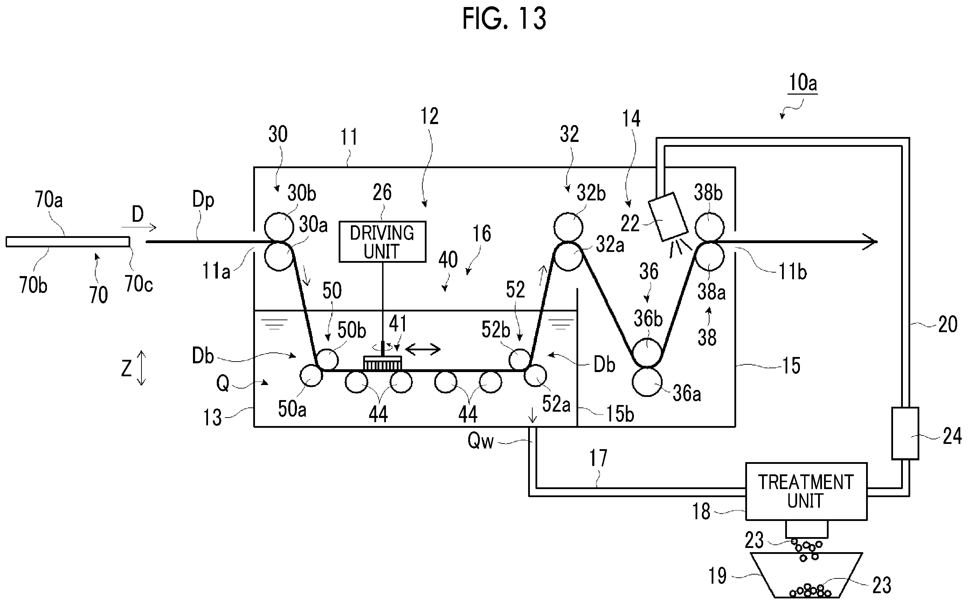

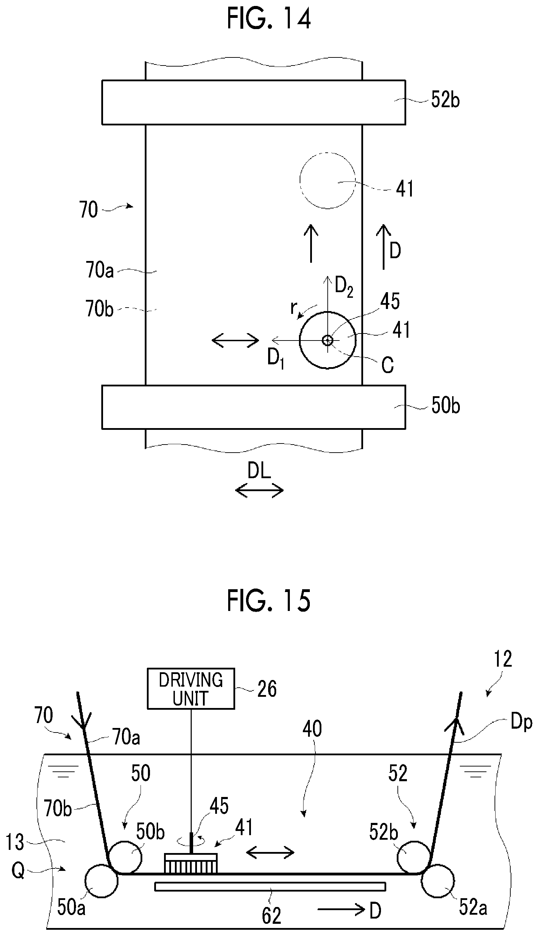

Fig. 13 is a schematic view showing a second example of the washing device according to the embodiment of the present invention. Fig. 14 is a schematic view showing a developing section of the second example of the washing device according to the embodiment of the present invention. In Figs. 13 and 14, the same components as those of the washing device 10 shown in Fig. 1 are denoted by the same reference numerals, and detailed description thereof is omitted.

A washing device 10a shown in Fig. 13 is different from the washing device 10 shown in Fig. 1 in that the transport path Dp of the flexographic printing plate precursor 70, the configuration of the transport unit 16, and the configuration of the development unit 40 are different, and the configurations other than the above configurations are the same as those of the washing device 10 shown in Fig. 1. Thus, detailed description thereof is omitted. Similar to the washing device 10 shown in Fig. 1, the washing device 10a is also a transport type washing device that performs development by transporting the flexographic printing plate precursor 70 along a predetermined transport path.

The transport unit 16 has a pair of transport rollers 50 and a pair of transport rollers 52 arranged spaced from each other in the developing tank 13 instead of the guide roller 34a (refer to Fig. 1). The flexographic printing plate precursor 70 is transported substantially horizontally in the developing tank 13. In the developing tank 13, the transport path Dp is linear.

In the development unit 40, for example, one brush 41 that is in contact with the surface 70a of the flexographic printing plate precursor 70 is arranged. In addition, the plurality of guide rollers 44 are arranged opposite to the brush 41 with the flexographic printing plate precursor 70 interposed therebetween. In a case where the flexographic printing plate precursor 70 is transported, the unexposed portion is removed by the brush 41.

In the washing device 10a, in a case where the flexographic printing plate precursor 70 is transported, the unexposed portion is removed by the brush 41, and the flexographic printing plate precursor 70 can be developed similar to the washing device 10 shown in Fig. 1. Therefore, the effects similar to the washing device 10 shown in Fig. 1 can be acquired.

As shown in Fig. 14, the washing device 10a is, for example, configured to move the brush 41 in two directions orthogonal to the rotation axis C, using the first movement direction D₁ as the direction DL and the second movement direction D₂ as the transporting direction D. However, as described above, a configuration in which the movement is caused in the first movement direction D₁, that is, only in the direction DL may be adopted.

Since the brush 41 is smaller than the surface 70a of the flexographic printing plate precursor 70 as described above, development is performed by partially applying the brush 41 to the entire width of the flexographic printing plate precursor 70. As described above, during development, the brush 41 is small, and is thus caused to move in orthogonal two directions, for example. In addition to moving the brush 41 in orthogonal two directions, a configuration in which the brush 41 may be caused to move in at least one direction intersecting the rotation axis, for example, in the direction DL may be adopted. As above, by moving the brush 41, it is possible to efficiently perform development with the small brush 41.

During the development, as long as the brush 41 can evenly rub an entire surface 70a of the flexographic printing plate precursor 70, the movement direction of the brush 41 is not particularly limited.

Also, the movement path of the brush 41 is determined in advance according to the size of the brush 41, the size of the flexographic printing plate precursor 70, the transport speed, and the like. As a result, the movement path of the brush 41 can be programmed, whereby development can be performed based on the program.

Further, also in the washing device 10a, as described above, the outside of the flexographic printing plate precursor 70 can be used as a retraction site for the brush 41. In a case of removing the development scum, the brush 41 is cased to move to the retraction site. In addition to this, a configuration in which development time and a development processing area may be set, and in a case where the development time and the development processing area are exceeded, the brush 41 may be caused to move to the retraction site may be adopted.

Further, also in the washing device 10a, in order to efficiently discharge the development scum inside the brush 41 to the outside of the brush 41, a washing solution may be supplied to the brush 41 at the retraction site of the brush 41 so that the development scum may be discharged to the outside of the brush 41.

Even in the washing device 10a, since the flexographic printing plate precursor 70 is transported while being interposed between the brush 41 and the guide roller 44, the unexposed portion can be efficiently removed and the flexographic printing plate precursor 70 can be more stably transported.

The number of brushes 41 and the number of guide rollers 44 are appropriately determined depending on the size of the developing tank 13, the size of the flexographic printing plate precursor 70, and the like.

In the washing device 10a shown in Fig. 13, the configurations of the transport unit 16 and the development unit 40 are not limited to those described above, and other configurations may be adopted.

Here, Fig. 15 is a schematic view showing another example of the developing section of the second example of the washing device according to the embodiment of the present invention. In Fig. 15, the same components as those of the washing device 10a shown in Fig. 13 are denoted by the same reference numerals, and detailed description thereof is omitted.

As shown in Fig. 15, the development unit 40 may include a brush 41 arranged on the surface 70a side of the flexographic printing plate precursor 70 and a support 62 arranged oppositely with the flexographic printing plate precursor 70 interposed therebetween.

One support 62 may be used and a plurality of the supports 62 may be arranged by adjusting the size of the support. As the support 62, the same support as the support 42 shown in Figs. 5 and 6 described above can be used.

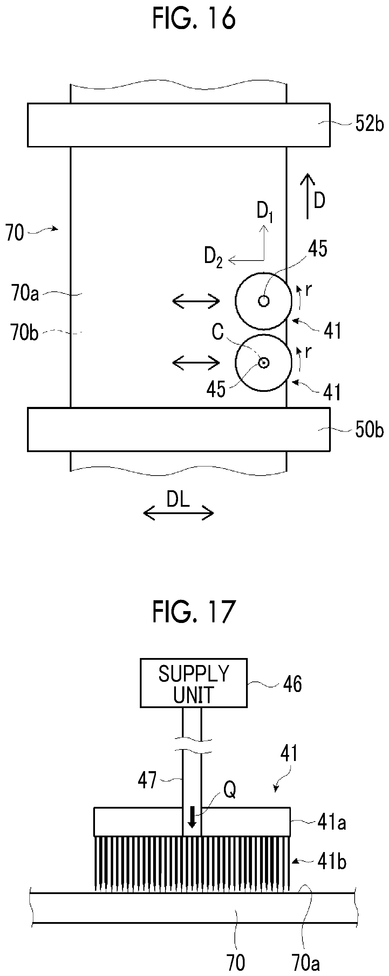

Fig. 16 is a schematic view showing still another example of the developing section of the second example of the washing device according to the embodiment of the present invention.

The brush 41 provided in the development unit 40 of the washing device 10a is not limited to one, and may be a plurality of brushes 41 may be used, similar to the washing device 10 described above. For example, as shown in Fig. 16, a configuration having two brushes 41 may be used.

It is possible to perform development with two brushes 41 at the same time. As a result, an area rubbed by the brush 41 is increased, and the development speed can be increased in a state in which the adhesion of development scum is suppressed and the development uniformity is maintained. In this case, the rotating speed of the plurality of brushes 41 may be the same, or the rotating speed may be changed for each of the plurality of brushes 41. Further, the two brushes 41 may have the same size or different sizes.

In the two brushes 41, for example, one motor may drive at least two brushes at the same time as described above, instead of rotating each brush 41 individually. As a result, the number of motors can be reduced and the device can be miniaturized. Even in a case where a plurality of brushes are rotated by one motor, the rotation speed can be changed for each brush by providing a transmission as described above.

The flexographic printing plate precursor 70 is developed in a state of being immersed in the washing solution Q, but the development is not limited thereto, and the development can be performed while supplying the washing solution Q to the brush 41. In this case, as a configuration of the brush 41, for example, as shown in Fig. 17, the brush 41 provided with a supply pipe 47 may be adopted. The supply pipe 47 is connected to a supply unit 46 that supplies the washing solution Q. The washing solution Q is supplied from the supply unit 46 to the brush 41 via the supply pipe 47, and the washing solution Q is supplied between the brush 41 and the surface 70a of the flexographic printing plate precursor 70.

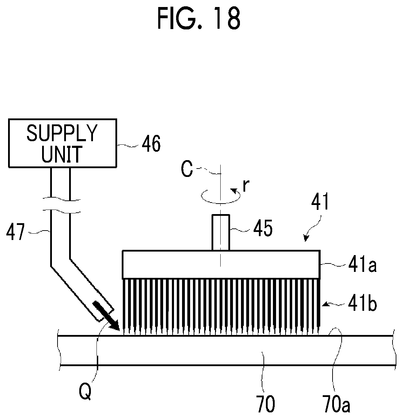

Further, as shown in Fig. 18, the supply pipe 47 may be provided outside the brush 41 to supply the washing solution Q between the brush 41 and the surface 70a of the flexographic printing plate precursor 70. In this case, development can be performed while supplying the washing solution Q to the brush 41 from the supply unit 46 via the supply pipe 47.

It is preferable to perform development while supplying the washing solution Q in that the adhesion of the development scum is suppressed.

The above-described transport unit 16 has been described by taking the roller transport system as an example, but is not limited thereto. The transport unit 16 can adopt, for example, at least one of a belt transport system, the above-described roller transport system, a gear transport system, or a guide transport system.

In the case of the belt transport system, for example, in the washing device 10a shown in Fig. 13, an endless belt (not shown) is arranged instead of the guide roller 44, and this endless belt is driven by a driving unit (not shown) to transport the flexographic printing plate precursor 70.

In the case of the gear transport system, for example, a jig (not shown) having gears at both ends for transporting the flexographic printing plate precursor 70 (not shown) is attached to an end portion 70c (refer to Figs. 1 and 13) of the flexographic printing plate precursor 70. The flexographic printing plate precursor 70 is transported by engaging the gear of the jig with the driving gear and rotating the driving gear. A ball spline gear can also be used in the gear transport system.

In the case of the guide transport system, for example, a strip member (not shown) for transporting the flexographic printing plate precursor 70 (not shown) is attached to the end portion 70c (refer to Figs. 1 and 13) of the flexographic printing plate precursor 70, and the strip member is allowed to pass through, for example, the outlet 11b of the housing 11 and is wound outside the outlet 11b to transport the flexographic printing plate precursor 70.

The flexographic printing plate precursor 70 forms a flexographic printing plate used for flexographic printing, and the configuration thereof is not particularly limited. The flexographic printing plate precursor 70 is as thin as about several millimeters and has flexibility. In addition, having flexibility means returning to the original state after unloading the force from the bent state due to the action of the force. The size of the flexographic printing plate precursor 70 is, for example, 800 mm × 1200 mm or 1050 mm × 1500 mm. Since the development is performed by moving the brush 41, it is possible to be compatible with a large flexographic printing plate precursor 70.

The flexographic printing plate precursor 70 is preferably a precursor that can be developed by an aqueous developer having water as a main component, or a water developing type flexographic printing plate precursor. In this case, the washing solution is an aqueous developer.

As the flexographic printing plate precursor 70, a known flexographic printing plate precursor that can be developed by an aqueous developer can be used. As the flexographic printing plate precursor 70, a flexographic plate material compatible with a computer to plate (CTP) having a black layer applied to the surface thereof may be used.

Hereinafter, the washing solution will be described.

### <Washing Solution>

The washing solution is preferably an aqueous washing solution, and may be a liquid consisting solely of water, or an aqueous solution containing 50% by mass or more of water and a water-soluble compound added thereto. Examples of water-soluble compounds include surfactants, acids, and alkalis. The above aqueous washing solution corresponds to an aqueous developer.

Examples of the surfactant include an anionic surfactant, a nonionic surfactant, a cationic surfactant, and an amphoteric surfactant, and among these, an anionic surfactant is preferable.

Specific examples of the anionic surfactant include aliphatic carboxylates such as sodium laurate and sodium oleate; higher alcohol sulfate ester salts such as sodium lauryl sulfate, sodium cetyl sulfate, and sodium oleyl sulfate; polyoxyethylene alkyl ether sulfate ester salts such as sodium polyoxyethylene lauryl ether sulfate; polyoxyethylene alkylaryl ether sulfate ester salts such sodium polyoxyethylene octylphenyl ether sulfate, and sodium polyoxyethylene nonylphenyl ether sulfate; alkyl sulfate salts such as alkyldiphenyl ether disulfonate salt, sodium dodecyl sulfonate, and sodium dialkyl sulfosuccinate; alkylaryl sulfonate salts such as alkyl disulfonate salt, sodium dodecylbenzene sulfonate, sodium dibutylnaphthalene sulfonate, and sodium triisopropylnaphthalene sulfonate; higher alcohol phosphate ester salts such as disodium lauryl phosphate monoester and sodium lauryl phosphate diester; and polyoxyethylene alkyl ether phosphate ester salts such as disodium polyoxyethylene lauryl ether phosphate monoester, and sodium polyoxyethylene laurylether phosphate diester. These may be used alone or in combination of two or more thereof. As specific examples, sodium salts are mentioned, but the surfactant is not particularly limited to the sodium salts. The same effects can be obtained using calcium salts or ammonia salts.

Specific examples of the nonionic surfactant include alkaline salt compounds such as polyoxyethylene alkyl ethers such as polyoxyethylene oleyl ether and polyoxyethylene lauryl ether, polyoxyethylene polyoxypropylene glycols such as polyoxyethylene alkylphenyl ethers such as polyoxyethylene nonyl phenyl ether and polyoxyethylene octyl phenyl ether, mono- and diesters of fatty acids with polyethylene glycol such as polyethylene glycol monostearate, polyethylene glycol monooleate, and polyethylene glycol dilaurate, esters of fatty acids with sorbitan such as sorbitan monolaurate and sorbitan monooleate, esters of polyoxyethylene adducts of sorbitan with fatty acids such as polyoxyethylene sorbitan monolaurate, polyoxyethylene sorbitan monostearate, and polyoxyethylene sorbitan trilaurate, esters of fatty acids and sorbitol such as sorbitol monopalmitate and sorbitol dilaurate, esters of polyoxyethylene adducts of sorbitol and fatty acids such as polyoxyethylene sorbitol monostearate and polyoxyethylene sorbitol dioleate, esters of fatty acids with pentaerythriol such as pentaerythritol monostearate, esters of fatty acid with glycerin such as glycerin monolaurate, fatty acid alkanolamides such as lauric acid diethanolamide and lauric acid monoethanolamide, amine oxides such as lauryldimethylamine oxide, fatty acid alkanolamines such as stearyldiethanolamin, polyoxyethylene alkylamines, triethanolamine fatty acid esters, phosphates, carbonates, and silicates. These may be used alone or in combination of two or more thereof.

Specific examples of the cationic surfactant include primary, secondary, and tertiary amine salts such as monostearylammonium chloride, distearyl ammonium chloride, and tristearylammonium chloride, quaternary ammonium salts such as stearyltrimethylammonium chloride, distearyldimethyl ammonium chloride, and stearyldimethylbenzylammonium chloride, alkyl-pyridinium salts such as N-cetylpyridinium chloride and N-stearylpyridinium chloride, N,N-dialkylmorpholinium salts, fatty acid amide salts of polethylenepolyamine, acetic acid salts of urea compounds of amides of aminoethylethanolamine and stearic acid, and 2-alkyl-1-hydroxy-ethylimidazolinium chloride. These may be used alone or in combination of two or more thereof.

Specific examples of the amphoteric surfactant include amino acid type amphoteric surfactants such as sodium laurylaminepropionate, carboxy betaine type amphoteric surfactants such as lauryldimethylbetaine and lauryldihydroxyethylbetaine, sulfobetaine type amphoteric surfactants such as stearyldimethylsulfoethyleneammonium betaine, imidazoliniumbetaine type amphoteric surfactants, and lecithin. These may be used alone or in combination of two or more thereof.

Specific examples of acids include inorganic and organic acids such as hydrochloric acid, sulfuric acid, nitric acid, phosphoric acid, formic acid, acetic acid, oxalic acid, succinic acid, citric acid, malic acid, maleic acid, and paratoluensulfonic acid.

Specific examples of alkalis include lithium hydroxide, sodium hydroxide, magnesium hydroxide, potassium hydroxide, calcium hydroxide, calcium oxide, sodium carbonate, sodium hydrogen carbonate, and calcium carbonate.

Hereinafter, the development fatigue liquid will be described in detail.

### <Development Fatigue Liquid>

The development fatigue liquid is not particularly limited as long as the liquid is a washing solution including solids generated by removing the unexposed portion of the flexographic printing plate precursor by the development using the above washing solution, that is, a washing solution including an uncured resin. However, a development fatigue liquid containing a conventionally known photosensitive resin composition for forming a general photosensitive resin layer may also be included.

The uncured resin removed by development may be a photosensitive resin included in the photosensitive resin composition.

In addition, since it is preferable that the development fatigue liquid in a case of performing development by a laser ablation masking (LAM) method is an object to be treated, the uncured resin removed by development is preferably a photosensitive resin included in a photosensitive resin composition.

As such a photosensitive resin composition includes, for example, a composition containing a polymerization initiator, a polymerizable compound, a polymerization inhibitor, a plasticizer, and the like in addition to the photosensitive resin may be used. Thus, the development fatigue liquid may contain a polymerization initiator, a polymerizable compound, a polymerization inhibitor, a plasticizer, and the like in addition to the uncured resin.

### <Uncured Resin>

The uncured resin included in the development fatigue liquid refers to a solid generated by removing the unexposed portion. Examples of the uncured resin included in the development fatigue liquid include a water dispersible latex, a rubber component, a polymer component, and a noncrosslinked ethylenically unsaturated compound (polymer).

Examples of the water dispersible latex include water dispersible latex polymers of water dispersible latexes such as a polybutadiene latex, a natural rubber latex, a styrene-butadiene copolymer latex, an acrylonitrile-butadiene copolymer latex, a polychloroprene latex, a polyisoprene latex, a polyurethane latex, a methyl methacrylate-butadiene copolymer latex, a vinylpyridine copolymer latex, a butyl polymer latex, a thiokol polymer latex, and an acrylate polymer latex, and a polymer obtained by copolymerization of one of the above-described polymers and another component such as acrylic acid and methacrylic acid.

Examples of the rubber component include butadiene rubber, isoprene rubber, styrene-butadiene rubber, acrylonitrile rubber, acrylonitrile butadiene rubber, chloroprene rubber, polyurethane rubber, silicon rubber, butyl rubber, ethylene-propylene rubber, and epichlorohydrin rubber.

The polymer component may be hydrophilic or hydrophobic, and specific examples thereof include a polyamide resin, an unsaturated polyester resin, an acrylic resin, a polyurethane resin, a polyester resin, and a polyvinyl alcohol resin.

The solid having a specific gravity lower than that of the washing solution is, for example, a photosensitive resin such as a rubber component or latex.

The solid having a higher specific gravity than the washing solution is a component of an overcoat layer such as carbon.

Examples of the ethylenically unsaturated compound (polymer) include a (meth)acryl-modified polymer having an ethylenically unsaturated bond in the molecule.

Examples of the (meth)acryl-modified polymer include (meth)acryl-modified butadiene rubber and (meth)acryl-modified nitrile rubber.

The expression "(meth)acryl" is a notation representing acryl or methacryl, and the expression "(meth)acrylate" described later is a notation representing acrylate or methacrylate.

The uncured resin included in the development fatigue liquid is not particularly limited and the amount thereof is preferably 70% by mass or less and more preferably 35% by mass or less.

### <Polymerization Initiator>

The polymerization initiator that may be included in the development fatigue liquid is preferably a photopolymerization initiator.

Examples of the photopolymerization initiator include alkylphenones, acetophenones, benzoin ethers, benzophenones, thioxanthones, anthraquinones, benzils, and biacetyls. Among these, alkylphenones are preferable.

Specific examples of photopolymerization initiators of alkylphenones include 2,2-dimethoxy-1,2-diphenylethane-1-one, 1-hydroxy-cyclohexyl-phenyl-ketone, and 2-hydroxy- 2-methyl-1-phenyl-propan-1-one.

The concentration of the polymerization initiator that may be included in the development fatigue liquid is not particularly limited and is preferably 2.0% by mass or less and more preferably 1.0% by mass or less.

### <Polymerizable Compound>

Examples of the polymerizable compound that may be included in the development fatigue liquid include ethylenically unsaturated compounds corresponding to so-called monomer components other than the above-described ethylenically unsaturated compounds (polymers).

The ethylenically unsaturated compound may be a compound having one ethylenically unsaturated bond or a compound having two or more ethylenically unsaturated bonds.

Specific examples of the compound having one ethylenically unsaturated bond include a (meth)acrylate having a hydroxyl group such as 2-hydroxyethyl(meth)acrylate, 2-hydroxypropyl(meth)acrylate, 2-hydroxybutyl(meth)acrylate, 3-chloro-2-hydroxypropyl (meth)acrylate, and β-hydroxy-β'-(meth)acryloyloxyethyl phthalate; an alkyl(meth)acrylate such as methy(meth)acrylate, ethyl(meth)acrylate, propyl(meth)acrylate, butyl(meth)acrylate, isoamyl(meth)acrylate, 2-ethylhexyl(meth)acrylate, lauryl(meth)acrylate, and stearyl(meth)acrylate; a cycloalkyl(meth)acrylate such as cyclohexyl(meth)acrylate; halogenated alkyl(meth)acrylates such as chloroethyl(meth)acrylate, and chloropropyl(meth)acrylate; an alkoxyalkyl(meth)acrylate such as methoxyethyl(meth)acrylate, ethoxyethyl(meth)acrylate, and butoxyethyl(meth)acrylate; a phenoxyalkyl(meth)acrylate such as phenoxyethyl(meth)acrylate, and nonylphenoxyethyl(meth)acrylate; an alkoxyalkylene glycol(meth)acrylate such as ethoxydiethylene glycol(meth)acrylate, methoxytriethylene glycol(meth)acrylate, and methoxydipropylene glycol(meth)acrylate; 2,2-dimethylaminoethyl(meth)acrylate, 2,2-diethylaminoethyl(meth)acrylate, 2-hydroxyethyl (meth)acrylate, and 3-chloro-2-hydroxypropyl(meth)acrylate.

Specific examples of the ethylenically unsaturated compound containing two or more ethylenically unsaturated bonds include an alkyldioldi(meth)acrylate such as 1,9-nonanedioldi(meth)acrylate; a polyethylene glycoldi(meth)acrylate such as diethyleneglycoldi(meth)acrylate; a polypropylene glycoldi(meth)acrylate such as dipropyleneglycoldi(meth)acrylate; trimethylolpropane tri(meth)acrylate, pentaerythritol tri(meth)acrylate, pentaerythritol tetra(meth)acrylate, glycerol tri(meth)acrylate, a polyvalent (meth)acrylate obtained by an addition reaction of a compound having an ethylenically unsaturated bond such as an unsaturated carboxylic acid or an unsaturated alcohol and an activated hydrogen to ethylene glycol diglycidyl ether; a polyvalent(meth)acrylate obtained by an addition reaction of a compound having an active hydrogen such as a carboxylic acid and an amine to an unsaturated epoxy compound such as glycidyl(meth)acrylate; a polyvalent(meth)acrylamide such as methylene-bis-(meth)acrylamide; and a polyvalent vinyl compound such as divinylbenzene.

The concentration of the polymerizable compound that may be included in the development fatigue liquid is not particularly limited and is preferably 30.0% by mass or less and more preferably 15.0% by mass or less.

### <Polymerization Inhibitor>

Specific examples of the polymerization inhibitor that may be included in the development fatigue liquid include hydroquinone monomethyl ether, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitrosophenylhydroxylamine primary cerium salt.

The concentration of the polymerization inhibitor that may be included in the development fatigue liquid is not particularly limited and is preferably 0.3% by mass or less and more preferably 0.15% by mass or less.

### <Plasticizer>

Examples of the plasticizer that may be included in the development fatigue liquid include a liquid rubber, an oil, a polyester, and a phosphate compound.

Specific examples of the liquid rubber include a liquid polybutadiene, a liquid polyisoprene, and derivatives thereof modified by maleic acid or an epoxy group.

Specific examples of the oil include a paraffin, a naphthene, and an aromatic.

Specific examples of the polyester include an adipate polyester.

Specific examples of the phosphate compound include a phosphate ester.

The concentration of the plasticizer that may be included in the development fatigue liquid is not particularly limited and is preferably 30% by mass or less and more preferably 15% by mass or less.

The present invention is basically configured as described above. The washing device and the washing method according to the embodiment of the present invention have been described in detail above, but the present invention is not limited to the above-described embodiments. Various improvements or modifications may be of course made without departing from the scope of the present invention.

### [Examples]

The present invention will be described more specifically with reference to the following examples. The materials, reagents, used amounts, substance amounts, ratios, treatment details, treatment procedures, and the like shown in the following examples can be appropriately changed without departing from the scope of the present invention as defined in the appended claims. Accordingly, the scope of the present invention should not be construed as being limited by the specific examples shown below.

In the present example, the washing devices of Examples 1 to 21 and Comparative Examples 1 to 3 were evaluated for development uniformity, development speed, and adhesion of development scum.

Hereinafter, development uniformity, development speed, and adhesion of the development scum will be described. The development uniformity, the development speed, and the adhesion of the development scum are all evaluated by scores. The higher the scores, the better, and the practical level is 2 scores or more.

The development uniformity was evaluated by a floor thickness or a brush mark in the flexographic printing plate precursor after a development treatment. The brush mark was visually evaluated.

As will be described later, the flexographic printing plate precursor is back-exposed during imagewise exposure. By the back exposure, a part in the thickness of the flexographic printing plate precursor is cured even in the unexposed portion. The thickness of the cured part is the floor thickness. That is, the floor thickness is a film thickness of the unexposed portion after complete development.

The evaluation standards for development uniformity are shown in Table 1 below. The higher the score, the better the development uniformity.

**[Table 1]**

| Evaluation Standard of development uniformity | |
|---|---|
| Score | Description |
| 1 | A washed plate has unevenness in floor thickness or a brush mark remains and in a case where the plate is used for printing, print gets dirty. |
| 2 | A washed plate has floor thickness unevenness or a brush mark remains and in a case where the plate is used for printing, print gets dirty but is in an acceptable level. |
| 3 | A washed plate has floor thickness unevenness or a brush mark remains. However, even in a case where the plate is used for printing, print does not dirty. |
| 4 | There is a very small unevenness in floor thickness, but even in a case of using the plate, print does not dirty. |
| 5 | There is no unevenness of scraping or a brush mark at all in the plate after development completion. |

The development speed was evaluated by an average development speed of the unexposed portion. The evaluation standards for development speed are shown in Table 2 below. The higher the score, the better the development speed.

A value obtained by dividing a value obtained by subtracting an average value (mm) of values measured for the unexposed portion film thickness after development measured at 10 points with a contact type film thickness meter from the film thickness of the flexographic printing plate precursor before the exposure by the time (minutes) required for development was set as an average development speed of the above-described unexposed portion.

**[Table 2]**

| Evaluation Standard of development speed | |
|---|---|
| Score | Description |
| 1 | An average development speed of an unexposed portion is lower than 0.05 mm/min. |
| 2 | An average development speed of an unexposed portion is from 0.05 mm/min to lower than 0.07 mm/min. |
| 3 | An average development speed of an unexposed portion is from 0.07 mm/min to lower than 0.1 mm/min. |
| 4 | An average development speed of an unexposed portion is from 0.1 mm/min to lower than 0.15 mm/min. |
| 5 | An average development speed of an unexposed portion is from 0.15 mm/min or higher. |

Regarding the adhesiveness of the development scum, the presence or absence of the development scum in the flexographic printing plate precursor after a development treatment was visually evaluated. The evaluation standards for the adhesion of the development scum are shown in Table 3 below. The higher the score, the better the adhesion of the development scum. That is, the development scum does not adhere.

**[Table 3]**

| Evaluation Standard of adhesion of development scum | |
|---|---|
| Score | Description |
| 1 | Scum adhesion on a plate occurs on every plate. |
| 2 | Sometimes there is a plate where scum on a plate does not occur (there are 1 to 5 plates having no scum out of 20 plates) |
| 3 | Scum adhesion on a plate occurs rarely (there are 1 or 2 plates having 2 or 3 scums out of 20 plates) |
| 4 | Scum adhesion on a plate does not occur, but scum remains in a brush. |
| 5 | Scum adhesion on a plate does not occur, and scum does not remain in a brush. |

The devices and chemicals used in Examples 1 to 21 and Comparative Examples 1 to 3 are shown below.

### <Imaging Machine>

· CDI Spark 4835 Inline (manufactured by Esko-Graphics BV.)

### <Exposure Machine >

· Ultraviolet exposure machine Concept 302 ECDLF (tradename) (manufactured by Glunz&Jensen)

### <Flexographic Printing Plate Precursor>

· FLENEX FW-L (manufactured by Fujifilm Global Graphic Systems Co., Ltd.)
· Plate size 800 mm × 1200 mm

### <Washing Solution>

· Aqueous solution of FINISH POWER & PURE POWDER SP (manufactured by Reckitt Benckiser Japan Ltd.) (concentration: 0.5% by mass)
· Liquid temperature 50°C

### <Imagewise Exposure of Flexographic Printing Plate Precursor>

The above flexographic printing plate precursor was back-exposed by exposing the flexographic printing plate precursor for 10 seconds with 80 W energy from the back surface of the flexographic printing plate precursor using the above-mentioned UV exposure machine. Then, a mask layer was imaged by ablation using the above imaging machine, and main exposure was performed from the surface (the back surface of the back surface) at 80 W for 1000 seconds. The flexographic printing plate precursor subjected to main exposure was used as a flexographic printing plate precursor after imagewise exposure.

### <Centrifuge>

· UB-S1 (manufactured by Ameroid Japan Service Co., Ltd.)
<Brush>
· Brush of SB-926 (manufactured by GS TR Co., Ltd.) was used by adjusting to each size.

### <Rinse>

· Tap water Supplied using a spray pipe
· Flow rate 5 liters/m²

### <Drying>

After the development treatment and the rinsing treatment, drying was performed at a temperature of 60°C for 10 minutes.

Next, Examples 1 to 21 and Comparative Examples 1 to 3 will be described.

### (Example 1)

In Example 1, in the washing device shown in Fig. 1, two brushes were arranged on an outside as shown in Fig. 9, and the flexographic printing plate precursor after the imagewise exposure described above was developed by moving the brushes in one direction of a short side direction of the flexographic printing plate precursor. Therefore, "1 axis" was noted in a column of "Drive of rotation axis of brush".

In Example 1, the rotation axis of the brush was the center of the brush, the rotation speed of the brush was 50 rpm, and the size of the brush was 200 mm in diameter. The brush was arranged with an angle θ shown in Fig. 4 set to 90°.

Further, in Example 1, the two brushes were rotated individually. In addition, the washing solution was not supplied to the brush, and the brush was not retracted. In Example 1, the support 42 shown in Fig. 9 was not arranged.

### (Example 2)

Example 2 was the same as Example 1 except that as compared to Example 1, the development was performed by moving the brushes in orthogonal two directions. In Example 2, the movement was caused in a longitudinal direction orthogonal to a short side direction in addition to the short side direction of the flexographic printing plate precursor, and the development was performed by moving the brush in or two directions. Therefore, "Orthogonal two axes" was noted in the column of "Drive of rotation axis of brush".

### (Example 3)

Example 3 was the same as Example 2 except that as compared to Example 2, a position of the rotation axis of the brush was intermediate between the center of the brush and an edge of the brush.

### (Example 4)

Example 4 was the same as Example 2 except that as compared to Example 2, the position of the rotation axis of the brush is the edge of the brush.

### (Example 5)

Example 5 was the same as Example 2 except that as compared to Example 2, the rotation speed of the brush was 100 rpm.

### (Example 6)

Example 6 was the same as Example 2 except that as compared to Example 2, the rotation speed of the brush was 800 rpm.

### (Example 7)

Example 7 was the same as Example 2 except that as compared to Example 2, the rotation speed of the brush was 1500 rpm.

### (Example 8)

Example 8 was the same as Example 2 except that as compared to Example 2, the rotation speed of the brush was 2000 rpm.

### (Example 9)

Example 9 was the same as Example 2 except that as compared to Example 2, the rotation speed of the brush was 10 rpm.

### (Example 10)

Example 10 was the same as Example 5 except that as compared to Example 5, the size of the brush was 30 mm in terms of diameter.

### (Example 11)

Example 11 was the same as Example 5 except that as compared to Example 5, the size of the brush was 500 mm in terms of diameter.

### (Example 12)

Example 12 was the same as Example 5 except that as compared to Example 5, the size of the brush was 600 mm in terms of diameter.

### (Example 13)

Example 13 was the same as Example 2 except that as compared to Example 2, the rotation speed of the brush was 10 rpm and the washing solution was supplied from the center of the rotation axis at 300 cc/min as shown in Fig. 17.

### (Example 14)

Example 14 was the same as Example 2 except that as compared to Example 2, the rotation speed of the brush was 10 rpm and the washing solution was supplied between the brush and the flexographic printing plate precursor from the side of the brush at 1000 cc/min as shown in Fig. 18.

### (Example 15)

Example 15 is the same as Example 2 except that as compared to Example 2, the rotation speed of the brush was 10 rpm and the brush was attached and detached once for each reciprocation of the rotation axis of the brush. Example 15 has a configuration in which the brush was retracted.

### (Example 16)

Example 16 was the same as Example 5 except that as compared to Example 5, two brushes were synchronously rotated by a belt drive from one motor.

### (Example 17)

In Example 17, development was performed by moving the brush in orthogonal two directions using a horizontal transport type washing device that horizontally transports the flexographic printing plate precursor after the imagewise exposure described above as shown in Fig. 13. In Example 17, since the development was performed by moving the brush in orthogonal two directions, "Orthogonal two axes" was noted in the column of "Drive of rotation axis of brush".

In Example 17, the rotation axis of the brush was the center of the brush, the rotation speed of the brush was 100 rpm, and the size of the brush was 200 mm in terms of diameter. The brush was arranged with an angle θ shown in Fig. 4 set to 90°.

Further, in Example 17, the two brushes were rotated individually. In addition, the washing solution was not supplied to the brush, and the brush was not retracted.

### (Example 18)

Example 18 was the same as Example 5 except that, as compared to Example 5, the brush was arranged with the angle θ shown in Fig. 4 set to 45°.

### (Example 19)

Example 19 was the same as Example 1 except that as compared to Example 1, the shaft joint unit 80 shown in Fig. 10 was provided.

### (Example 20)

Example 20 was the same as Example 1 except that as compared to Example 1, the shaft joint unit 81 shown in Fig. 11 was provided.

### (Example 21)

Example 21 was the same as Example 1 except that as compared to Example 1, the shaft joint unit 80 and the pressing unit 90 shown in Fig. 12 were provided.

### (Comparative Example 1)

In Comparative Example 1, a device configuration was different as compared to Example 1, and the rotation axis of the brush was outside the brush. Further, in Comparative Example 1, the brush is rotated so that the rotation axis of the brush itself makes a circular motion at a rotation speed of 48 rpm, that is, revolves. Except for these, Comparative example 1 was the same as Example 1. In Comparative Example 1, transport was not in one direction.

Comparative Example 1 corresponds to JP1999-133625A (JP-H11-33625A).

### (Comparative Example 2)

Comparative Example 2 has a different device configuration as compared to Example 1. The rotation axis of the brush was in the center of the brush, but during rotation, the rotation axis was not fixed and the rotation axis itself rotates on a circle of a defined diameter. Except for these, Comparative example 1 was the same as Example 1.

Comparative Example 2 corresponds to JP2005-208371A.

### (Comparative Example 3)

Comparative Example 3 was the same as Example 1 except that as compared to Example 1, the brush in which the rotation axis was parallel to the surface of the flexographic printing plate precursor was used.

**[Table 4]**

| | Position of rotation axis of brush | Rotation speed of brush (rpm) | Diameter of brush (mm) | Drive of rotation axis of brush | Supply of washing solution | Retraction of brush | Evaluation item | | |
|---|---|---|---|---|---|---|---|---|---|
| | | | | | | | Development uniformity | Development speed | Adhesion of development |
| Example 1 | Center | 50 | 200 | Single axis | NO | NO | 3 | 3 | 4 |
| Example2 | Center | 50 | 200 | Orthogonal two axes | NO | NO | 4 | 4 | 4 |
| Example3 | Intermediate between edge of brush and center of brush | 50 | 200 | Orthogonal two axes | NO | NO | 3 | 4 | 4 |
| Example4 | Center | 50 | 200 | Orthogonal two axes | NO | NO | 3 | 4 | 4 |
| Example5 | Center | 100 | 200 | Orthogonal two axes | NO | NO | 5 | 5 | 5 |
| Example6 | Center | 800 | 200 | Orthogonal two axes | NO | NO | 5 | 5 | 5 |
| Example7 | Center | 1500 | 200 | Orthogonal two axes | NO | NO | 4 | 5 | 5 |
| Example8 | Center | 2000 | 200 | Orthogonal two axes | NO | NO | 2 | 5 | 5 |
| Example9 | Center | 10 | 200 | Orthogonal two axes | NO | NO | 3 | 3 | 3 |
| Example 10 | Center | 100 | 30 | Orthogonal two axes | NO | NO | 5 | 3 | 5 |
| Example 11 | Center | 100 | 500 | Orthogonal two axes | NO | NO | 5 | 4 | 5 |
| Example 12 | Center | 100 | 600 | Orthogonal two axes | NO | NO | 5 | 4 | 4 |
| Example 13 | Center | 10 | 200 | Orthogonal two axes | YES | NO | 3 | 3 | 4 |
| Example 14 | Center | 10 | 200 | Orthogonal two axes | YES | NO | 3 | 3 | 4 |
| Example 15 | Center | 10 | 200 | Orthogonal two axes | NO | YES | 3 | 3 | 4 |
| Example 16 | Center | 100 | 200 | Orthogonal two axes | NO | NO | 5 | 5 | 5 |
| Example 17 | Center | 100 | 200 | Orthogonal two axes | NO | NO | 5 | 5 | 5 |
| Example 18 | Center | 100 | 200 | Orthogonal two axes | NO | NO | 4 | 4 | 4 |
| Example 19 | Center | 50 | 200 | Single axis | NO | NO | 5 | 4 | 4 |
| Example20 | Center | 50 | 200 | Single axis | NO | NO | 4 | 4 | 4 |
| Example21 | Center | 50 | 200 | Single axis | NO | NO | 5 | 5 | 5 |
| Comparative example 1 | Outside brush | 50 | 200 | Circular motion at 48 rpm | NO | NO | 1 | 2 | 2 |
| Comparative example 2 | Center | 50 | 200 | Single axis | NO | NO | 1 | 1 | 1 |
| Comparative example 3 | Center | 50 | 200 | Single axis | NO | NO | 2 | 2 | 2 |

As shown in Table 4, Examples 1 to 21 were superior in development uniformity, development speed, and adhesion of development scum as compared to Comparative Examples 1 to 3.

In Examples 1 and 2, it is preferable to move the brush in orthogonal two axes because the development uniformity and the development speed are excellent.

In Examples 2 to 4, it is preferable to set the rotation axis at the center of the brush because the development uniformity is excellent.

In Example 2 and Examples 5 to 9, the rotation speed of the brush is preferably 100 to 1500 rpm, and more preferably 100 to 800 rpm.

In Example 5 and Examples 10 to 12, in a case where the diameter of the brush is smaller than 200 mm, the development speed becomes low. In a case where the diameter of the brush exceeds 200 mm, the development speed becomes low, and development scum may adhere.

In Example 9 and Examples 13 to 15, in a case where the washing solution was supplied, the adhesion of the development scum was improved and the adhesion of the development scum was suppressed. Further, even in a case where the brush was retracted, the adhesion of the development scum was improved, and the adhesion of the development scum was suppressed.

In Example 5 and Example 16, results of development uniformity, development speed, and adhesion of development scum were the same even in a case where the two brushes were synchronized. In addition, Example 16 could achieve miniaturization comparing to Example 5 and could save space.

In Example 17, good results were obtained in all of the development uniformity, the development speed, and the adhesion of the development scum, regardless of the transport form of the flexographic printing plate precursor. In Example 17, since the device became large, a flow line of the operator became long.

In Examples 5 and 18, in a case where the brushes were arranged with the rotation axis set to 90°, the development uniformity, the development speed, and the adhesion of the development scum are excellent.

From Examples 1 and examples 19 to 21, it is preferable to provide the shaft joint unit because the development uniformity is more excellent. Further, it is more preferable to provide the shaft joint unit and the pressing unit because the development uniformity, the development speed, and the adhesion of the development scum were further excellent.

Further, in Example 19 and Example 20, since the development uniformity is excellent, it is preferable that the shaft joint unit is a universal joint.

### Explanation of References

10, 10a: washing device
11: housing
11a: inlet
11b: outlet
12: developing section
13: developing tank
14: rinsing section
15: rinsing tank
15b: side wall
16: transport unit
17: connection pipe
18: treatment unit
19: tray
20: pipe
22: supply unit
23: solid
24: separation membrane
26: driving unit
27: driving shaft portion
29: first pulley
29b: second pulley
30: pair of first transport rollers
30a, 30b: roller
32: pair of second transport rollers
32a, 32b: roller
34a, 44: guide roller
36, 38: pair of transport rollers
36a, 36b, 38a, and 38b: roller
40: development unit
41: brush
41a: substrate
41b: bristle
41c: tip surface
42: support
45, 45a: rotating shaft portion
46: supply unit
47: supply pipe
50, 52: pair of transport rollers
62: support
70: flexographic printing plate precursor
70a: surface
70b: back surface
70c: end portion
80: shaft joint unit
82: first member
84: second member
85: ball
86: first flange
87: second flange
88, 89, 94: elastic member
90: pressing unit
92: case
95: fixing wall
C: rotation axis
D: transporting direction
Db: transport path
Dc: driving axis
Dp: transport path
Q: washing solution
Qw: development fatigue liquid
r: rotation direction
θ: angle

## Claims

1. A washing device (10, 10a) that is configured to perform development on a flexographic printing plate precursor (70) after imagewise exposure using a washing solution (Q) while transporting the flexographic printing plate precursor (70), the device comprising:
a transport unit (16) that is configured to transport the flexographic printing plate precursor (70) along a predetermined transport path (Dp); and
a development unit (40) that is configured to perform the development on the flexographic printing plate precursor (70) by immersing the flexographic printing plate precursor (70) in the washing solution (Q),
wherein the development unit (40) includes a brush (41) which is configured to be used for the development and a driving unit (26) which is configured to control rotation of the brush (41) around a rotation axis (C) and movement of the brush (41),
the brush (41) is configured to remove an unexposed portion of the flexographic printing plate precursor (70) to perform the development,
the rotation axis (C) of the brush (41) is a fixed axis passing through one point in the brush (41), and
the driving unit (26) is configured to rotate the brush (41), in a state in which the rotation axis (C) of the brush (41) passes through a surface (70a) of the flexographic printing plate precursor (70), and moves the rotation axis (C) of the brush (41) in at least one direction intersecting the rotation axis (C).

2. The washing device (10, 10a) according to claim 1,
wherein an area of the brush (41) which is projected on a surface (70a) of the flexographic printing plate precursor (70) is smaller than an area of the surface (70a) of the flexographic printing plate precursor (70).

3. The washing device (10, 10a) according to a claim 1 or 2,
wherein the driving unit (26) is configured to move the rotation axis (C) of the rotation of the brush (41) in two directions with respect to the rotation axis (C).

4. The washing device (10, 10a) according to any one of claims 1 to 3,
wherein the rotation axis (C) of the brush (41) passes through a center of the brush (41).

5. The washing device (10, 10a) according to any one of claims 1 to 4,
wherein the driving unit (26) has a driving shaft portion (27) that is configured to rotate,
the brush (41) has a rotating shaft portion (45, 45a) having the rotation axis (C) as a central axis,
a shaft joint unit (80) that connects the driving shaft portion (27) of the driving unit (26) and the rotating shaft portion (45, 45a) of the brush (41) so as to transmit a rotational force of the driving shaft portion (27) of the driving unit (26) to the rotating shaft portion (45, 45a) of the brush (41) and is configured to adjust an inclination of the rotation axis (C) of the brush (41) with respect to the surface (70a) of the flexographic printing plate precursor (70), and
the inclination of the rotation axis (C) of the brush (41) is adjusted by the shaft joint unit (80) so that a tip surface (41c) of the brush (41) is arranged parallel to the surface (70a) of the flexographic printing plate precursor (70).

6. The washing device (10, 10a) according to claim 5,
wherein the shaft joint unit (80) has an elastic member (88, 89, 94) that is configured to press the tip surface (41c) of the brush (41) against the surface (70a) of the flexographic printing plate precursor (70).

7. The washing device (10, 10a) according to any one of claims 1 to 6,
wherein the development unit (40) includes a pressing unit (90) that is configured to press a tip surface (41c) of the brush (41) against the surface (70a) of the flexographic printing plate precursor (70).

8. The washing device (10, 10a) according to any one of claims 1 to 7,
wherein the driving unit (26) rotates the brush (41) at a rotation speed of 10 rpm to 2000 rpm.

9. The washing device (10, 10a) according to any one of claims 1 to 8,
wherein the brush (41) has a diameter of 30 mm to 500 mm.

10. The washing device (10, 10a) according to any one of claims 1 to 9,
wherein the driving unit (26) is configured to retract the brush (41) from the flexographic printing plate precursor (70).

11. The washing device (10, 10a) according to any one of claims 1 to 8,
wherein a plurality of the brushes (41) are provided, and
the driving unit (26) is configured to drive at least two brushes (41) at the same time with one motor.

12. The washing device (10, 10a) according to any one of claims 1 to 11,
wherein the washing solution (Q) is an aqueous developer.

13. The washing device according to any one of claims 1 to 12,
wherein the transport unit (16) is configured to adopt at least one of a belt transport system, a roller transport system, a gear transport system, or a guide transport system.

14. A washing method that performs development on a flexographic printing plate precursor (70) after imagewise exposure using a washing solution (Q), the method comprising:
a development step in which the flexographic printing plate precursor (70) is transported along a predetermined transport path (Dp) and is immersed in the washing solution (Q), and an unexposed portion of the flexographic printing plate precursor (70) is removed by a brush (41) to perform the development,
wherein the brush (41) rotates around a rotation axis (C) passing through one point in the brush (41), and
in the development step, the brush (41) is caused to rotate in a state in which the rotation axis (C) of the brush (41) passes through a surface (70a) of the flexographic printing plate precursor (70), and the rotation axis (C) of the brush (41) is caused to move in at least one direction intersecting the rotation axis (C).

15. The washing method according to claim 14,
wherein an area of the brush (41) which is projected on a surface of the flexographic printing plate precursor (70) is smaller than an area of the surface (70a) of the flexographic printing plate precursor (70).

16. The washing method according to claim 14 or 15,
wherein in the development step, the rotation axis (C) of the rotation of the brush (41) is caused to move in two directions with respect to the rotation axis (C).

17. The washing method according to any one of claims 14 to 16,
wherein the rotation axis (C) of the brush (41) passes through a center of the brush (41).

18. The washing method according to any one of claims 14 to 17,
wherein in the development step, an inclination of the rotation axis (C) of the brush (41) with respect to the surface (70a) of the flexographic printing plate precursor (70) is adjusted so that a tip surface (41c) of the brush (41) is arranged parallel to the surface (70a) of the flexographic printing plate precursor (70).

## Patentansprüche

1. Waschvorrichtung (10, 10a), die so konfiguriert ist, dass sie Entwicklung an einem Flexodruckplatten-Vorläufer (70) nach bildweiser Belichtung unter Verwendung einer Waschlösung (Q) durchführt, während sie den Flexodruckplatten-Vorläufer (70) transportiert, wobei die Vorrichtung umfasst:
eine Transporteinheit (16), die so konfiguriert ist, dass sie den Flexodruckplatten-Vorläufer (70) entlang eines vorbestimmten Transportwegs (Dp) transportiert; und
eine Entwicklungseinheit (40), die so konfiguriert ist, dass sie die Entwicklung an dem Flexodruckplatten-Vorläufer (70) durch Eintauchen des Flexodruckplatten-Vorläufers (70) in die Waschlösung (Q) durchführt,
wobei die Entwicklungseinheit (40) eine Bürste (41), die so konfiguriert ist, dass sie für die Entwicklung verwendet wird, und eine Antriebseinheit (26), die so konfiguriert ist, dass sie Drehung der Bürste (41) um eine Drehachse (C) und Bewegung der Bürste (41) steuert, enthält,
die Bürste (41) so konfiguriert ist, dass sie einen unbelichteten Abschnitt des Flexodruckplatten-Vorläufers (70) entfernt, um die Entwicklung durchzuführen,
die Drehachse (C) der Bürste (41) eine festgelegte Achse ist, die durch einen Punkt in der Bürste (41) verläuft, und
die Antriebseinheit (26) so konfiguriert ist, dass sie die Bürste (41) in einem Zustand, in dem die Drehachse (C) der Bürste (41) durch eine Oberfläche (70a) des Flexodruckplatten-Vorläufers (70) verläuft, dreht und die Drehachse (C) der Bürste (41) in mindestens einer Richtung, die die Drehachse (C) schneidet, bewegt.

2. Waschvorrichtung (10, 10a) nach Anspruch 1,
wobei eine Fläche der Bürste (41), die auf eine Oberfläche (70a) des Flexodruckplatten-Vorläufers (70) projiziert wird, kleiner als eine Fläche der Oberfläche (70a) des Flexodruckplatten-Vorläufers (70) ist.

3. Waschvorrichtung (10, 10a) nach einem Anspruch 1 oder 2,
wobei die Antriebseinheit (26) so konfiguriert ist, dass sie die Drehachse (C) der Drehung der Bürste (41) in zwei Richtungen in Bezug auf die Drehachse (C) bewegt.

4. Waschvorrichtung (10, 10a) nach einem der Ansprüche 1 bis 3,
wobei die Drehachse (C) der Bürste (41) durch eine Mitte der Bürste (41) verläuft.

5. Waschvorrichtung (10, 10a) nach einem der Ansprüche 1 bis 4,
wobei die Antriebseinheit (26) einen Antriebswellenabschnitt (27), aufweist, der so konfiguriert ist, dass er sich dreht,
die Bürste (41) einen Drehwellenabschnitt (45, 45a) mit der Drehachse (C) als einer Mittelachse aufweist,
eine Wellenverbindungseinheit (80), die den Antriebswellenabschnitt (27) der Antriebseinheit (26) und den Drehwellenabschnitt (45, 45a) der Bürste (41) verbindet, so dass sie eine Drehkraft des Antriebswellenabschnitts (27) der Antriebseinheit (26) auf den Drehwellenabschnitt (45, 45a) der Bürste (41) überträgt, und so konfiguriert ist, dass sie eine Neigung der Drehachse (C) der Bürste (41) in Bezug auf die Oberfläche (70a) des Flexodruckplatten-Vorläufers (70) anpasst, und
die Neigung der Drehachse (C) der Bürste (41) durch die Wellenverbindungseinheit (80) so angepasst wird, dass eine Spitzenfläche (41c) der Bürste (41) parallel zu der Fläche (70a) des Flexodruckplatten-Vorläufers (70) angeordnet ist.

6. Waschvorrichtung (10, 10a) nach Anspruch 5,
wobei die Wellenverbindungseinheit (80) ein elastisches Element (88, 89, 94), das so konfiguriert ist, dass es die Spitzenfläche (41c) der Bürste (41) gegen die Fläche (70a) des Flexodruckplatten-Vorläufers (70) drückt, aufweist.

7. Waschvorrichtung (10, 10a) nach einem der Ansprüche 1 bis 6,
wobei die Entwicklungseinheit (40) eine Druckeinheit (90), die so konfiguriert ist, dass sie eine Spitzenfläche (41c) der Bürste (41) gegen die Fläche (70a) des Flexodruckplatten-Vorläufers (70) drückt, enthält.

8. Waschvorrichtung (10, 10a) nach einem der Ansprüche 1 bis 7,
wobei die Antriebseinheit (26) die Bürste (41) mit einer Drehzahl von 10 U/min bis 2000 U/min dreht.

9. Waschvorrichtung (10, 10a) nach einem der Ansprüche 1 bis 8,
wobei die Bürste (41) einen Durchmesser von 30 mm bis 500 mm aufweist.

10. Waschvorrichtung (10, 10a) nach einem der Ansprüche 1 bis 9,
wobei die Antriebseinheit (26) so konfiguriert ist, dass sie die Bürste (41) von dem Flexodruckplatten-Vorläufer (70) zurückzieht.

11. Waschvorrichtung (10, 10a) nach einem der Ansprüche 1 bis 8,
wobei mehrere der Bürsten (41) vorgesehen sind, und
die Antriebseinheit (26) so konfiguriert ist, dass sie mindestens zwei Bürsten (41)gleichzeitig mit einem Motor antreibt.

12. Waschvorrichtung (10, 10a) nach einem der Ansprüche 1 bis 11,
wobei die Waschlösung (Q) ein wässriger Entwickler ist.

13. Waschvorrichtung nach einem der Ansprüche 1 bis 12,
wobei die Transporteinheit (16) so konfiguriert ist, dass sie mindestens eines von einem Bandtransportsystem, einem Rollentransportsystem, einem Zahnradtransportsystem und einem Führungstransportsystem annimmt.

14. Waschverfahren, das Entwicklung an einem Flexodruckplatten-Vorläufer (70) nach bildweiser Belichtung unter Verwendung einer Waschlösung (Q) durchführt, wobei das Verfahren umfasst:
einen Entwicklungsschritt, bei dem der Flexodruckplatten-Vorläufer (70) entlang eines vorbestimmten Transportwegs (Dp) transportiert wird und in die Waschlösung (Q) eingetaucht wird, und ein unbelichteter Abschnitt des Flexodruckplatten-Vorläufers (70) durch eine Bürste (41) entfernt wird, um die Entwicklung durchzuführen, wobei die Bürste (41) sich um eine Drehachse (C), die durch einen Punkt in der Bürste (41) verläuft, dreht, und
bei dem Entwicklungsschritt die Bürste (41) in einem Zustand, in dem die Drehachse (C) der Bürste (41) durch eine Oberfläche (70a) des Flexodruckplatten-Vorläufers (70) verläuft, veranlasst wird, sich zu drehen, und die Drehachse (C) der Bürste (41) veranlasst wird, sich in mindestens einer Richtung, die die Drehachse (C) schneidet, zu bewegen.

15. Waschverfahren nach Anspruch 14,
wobei eine Fläche der Bürste (41), die auf eine Oberfläche des Flexodruckplatten-Vorläufers (70) projiziert wird, kleiner als eine Fläche der Oberfläche (70a) des Flexodruckplatten-Vorläufers (70) ist.

16. Waschverfahren nach Anspruch 14 oder 15,
wobei bei dem Entwicklungsschritt die Drehachse (C) der Drehung der Bürste (41) veranlasst wird, sich in zwei Richtungen in Bezug auf die Drehachse (C) zu bewegen.

17. Waschverfahren nach einem der Ansprüche 14 bis 16,
wobei die Drehachse (C) der Bürste (41) durch eine Mitte der Bürste (41) verläuft.

18. Waschverfahren nach einem der Ansprüche 14 bis 17,
wobei bei dem Entwicklungsschritt eine Neigung der Drehachse (C) der Bürste (41) in Bezug auf die Oberfläche (70a) des Flexodruckplatten-Vorläufers (70) so angepasst wird, dass eine Spitzenfläche (41c) der Bürste (41) parallel zu der Oberfläche (70a) des Flexodruckplatten-Vorläufers (70) angeordnet ist.

## Revendications

1. Dispositif de lavage (10, 10a) qui est configuré pour effectuer de développement sur un précurseur de plaque d'impression flexographique (70) après exposition image par image en utilisant une solution de lavage (Q) tout en transportant le précurseur de plaque d'impression flexographique (70), le dispositif comprenant :
une unité de transport (16) qui est configurée pour transporter le précurseur de plaque d'impression flexographique (70) le long d'une voie de transport prédéterminée (Dp) ; et
une unité de développement (40) qui est configurée pour effectuer le développement sur le précurseur de plaque d'impression flexographique (70) en immergeant le précurseur de plaque d'impression flexographique (70) dans la solution de lavage (Q),
dans lequel l'unité de développement (40) inclut une brosse (41) qui est configurée pour être utilisée pour le développement, et une unité d'entraînement (26) qui est configurée pour contrôler la rotation de la brosse (41) autour d'un axe de rotation (C) et le mouvement de la brosse (41),
la brosse (41) est configurée pour enlever une partie non exposée du précurseur de plaque d'impression flexographique (70) pour effectuer le développement,
l'axe de rotation (C) de la brosse (41) est un axe fixe passant par un point de la brosse (41), et
l'unité d'entraînement (26) est configurée pour faire tourner la brosse (41), dans un état où l'axe de rotation (C) de la brosse (41) passe à travers une surface (70a) du précurseur de plaque d'impression flexographique (70), et déplace l'axe de rotation (C) de la brosse (41) dans au moins une direction croisant l'axe de rotation (C).

2. Dispositif de lavage (10, 10a) selon la revendication 1,
dans lequel une superficie de la brosse (41) qui est projetée sur une surface (70a) du précurseur de plaque d'impression flexographique (70) est inférieure à une superficie de la surface (70a) du précurseur de plaque d'impression flexographique (70).

3. Dispositif de lavage (10, 10a) selon une revendication 1 ou une revendication 2,
dans lequel l'unité d'entraînement (26) est configurée pour déplacer l'axe de rotation (C) de la rotation de la brosse (41) dans deux directions par rapport à l'axe de rotation (C).

4. Dispositif de lavage (10, 10a) selon l'une quelconque des revendications 1 à 3,
dans lequel l'axe de rotation (C) de la brosse (41) passe par un centre de la brosse (41).

5. Dispositif de lavage (10, 10a) selon l'une quelconque des revendications 1 à 4,
dans lequel l'unité d'entraînement (26) a une partie d'arbre d'entraînement (27) qui est configurée pour tourner,
la brosse (41) a une partie d'arbre de rotation (45, 45a) ayant l'axe de rotation (C) comme un axe central,
une unité de joint d'arbre (80) qui connecte la partie d'arbre d'entraînement (27) de l'unité d'entraînement (26) et la partie d'arbre de rotation (45, 45a) de la brosse (41) de manière à transmettre une force de rotation de la partie d'arbre d'entraînement (27) de l'unité d'entraînement (26) à la partie d'arbre de rotation (45, 45a) de la brosse (41) et est configurée pour ajuster une inclinaison de l'axe de rotation (C) de la brosse (41) par rapport à la surface (70a) du précurseur de plaque d'impression flexographique (70), et
l'inclinaison de l'axe de rotation (C) de la brosse (41) est ajustée par l'unité de joint d'arbre (80) de sorte qu'une surface de pointe (41c) de la brosse (41) est disposée parallèlement à la surface (70a) du précurseur de plaque d'impression flexographique (70).

6. Dispositif de lavage (10, 10a) selon la revendication 5,
dans lequel l'unité de joint d'arbre (80) a un élément élastique (88, 89, 94) qui est configuré pour presser la surface de pointe (41c) de la brosse (41) contre la surface (70a) du précurseur de plaque d'impression flexographique (70).

7. Dispositif de lavage (10, 10a) selon l'une quelconque des revendications 1 à 6,
dans lequel l'unité de développement (40) inclut une unité de pressage (90) qui est configurée pour presser une surface de pointe (41c) de la brosse (41) contre la surface (70a) du précurseur de plaque d'impression flexographique (70).

8. Dispositif de lavage (10, 10a) selon l'une quelconque des revendications 1 à 7, dans lequel l'unité d'entraînement (26) fait tourner la brosse (41) à une vitesse de rotation de 10 tr/min à 2000 tr/min.

9. Dispositif de lavage (10, 10a) selon l'une quelconque des revendications 1 à 8,
dans lequel la brosse (41) a un diamètre de 30 mm à 500 mm.

10. Dispositif de lavage (10, 10a) selon l'une quelconque des revendications 1 à 9,
dans lequel l'unité d'entraînement (26) est configurée pour rétracter la brosse (41) du précurseur de plaque d'impression flexographique (70).

11. Dispositif de lavage (10, 10a) selon l'une quelconque des revendications 1 à 8,
dans lequel une pluralité des brosses (41) sont prévues, et
l'unité d'entraînement (26) est configurée pour entraîner au moins deux brosses (41) en même temps avec un moteur.

12. Dispositif de lavage (10, 10a) selon l'une quelconque des revendications 1 à 11,
dans lequel la solution de lavage (Q) est un révélateur aqueux.

13. Dispositif de lavage selon l'une quelconque des revendications 1 à 12,
dans lequel l'unité de transport (16) est configurée pour adopter au moins l'un d'un système de transport par bande, d'un système de transport par rouleau, d'un système de transport par pignon et d'un système de transport par guide.

14. Procédé de lavage qui effectue de développement sur un précurseur de plaque d'impression flexographique (70) après exposition image par image en utilisant d'une solution de lavage (Q), le procédé comprenant :
une étape de développement dans laquelle le précurseur de plaque d'impression flexographique (70) est transporté le long d'une voie de transport prédéterminée (Dp) et est immergé dans la solution de lavage (Q), et une partie non exposée du précurseur de plaque d'impression flexographique (70) est enlevée par une brosse (41) pour effectuer le développement,
dans lequel la brosse (41) tourne autour d'un axe de rotation (C) passant par un point de la brosse (41), et
dans l'étape de développement, la brosse (41) est amenée à tourner dans un état où l'axe de rotation (C) de la brosse (41) passe à travers une surface (70a) du précurseur de plaque d'impression flexographique (70), et l'axe de rotation (C) de la brosse (41) est amené à se déplacer dans au moins une direction croisant l'axe de rotation (C).

15. Procédé de lavage selon la revendication 14,
dans lequel une superficie de la brosse (41) qui est projetée sur une surface du précurseur de plaque d'impression flexographique (70) est inférieure à une superficie de la surface (70a) du précurseur de plaque d'impression flexographique (70).

16. Procédé de lavage selon la revendication 14 ou la revendication 15,
dans lequel dans l'étape de développement, l'axe de rotation (C) de la rotation de la brosse (41) est amené à se déplacer dans deux directions par rapport à l'axe de rotation (C).

17. Procédé de lavage selon l'une quelconque des revendications 14 à 16,
dans lequel l'axe de rotation (C) de la brosse (41) passe par un centre de la brosse (41).

18. Procédé de lavage selon l'une quelconque des revendications 14 à 17,
dans lequel dans l'étape de développement, une inclinaison de l'axe de rotation (C) de la brosse (41) par rapport à la surface (70a) du précurseur de plaque d'impression flexographique (70) est ajustée de sorte qu'une surface de pointe (41c) de la brosse (41) est disposée parallèlement à la surface (70a) du précurseur de plaque d'impression flexographique (70).
